# EUROPEAN PATENT SPECIFICATION

(11) **EP 3 893 234 B1**
(45) Date of publication and mention of the grant of the patent: **07.10.2026**
(21) Application number: 21177344.5
(22) Date of filing: 16.08.2018
(51) Int. Cl.: G09G 3/20, G06T 9/00, H03M 7/46, H03M 7/48

(54) **ELECTRONIC DISPLAY BORDER GAIN SYSTEMS AND METHODS**
SYSTEM UND VERFAHREN ZUR VERSTÄRKUNG DER GRENZE EINER ELEKTRONISCHEN ANZEIGE
SYSTÈMES ET PROCÉDÉS DE GAIN DE BORDURE D'AFFICHAGE ÉLECTRONIQUE

(30) Priority: 11.09.2017 US 201715701086
(43) Date of publication of application: 13.10.2021
(62) Document number(s) of the earlier application(s) in accordance with Art. 76 EPC: 18189353.8 / 3 454 322
(73) Proprietor: Apple Inc., Cupertino, CA 95014 (US)
(72) Inventor: CHO, Myung-Je, Cupertino, CA, 95014 (US); CHOU, Jim, Cupertino, CA, 95014 (US); ALBRECHT, Marc, Cupertino, CA, 95014 (US); GUILLOU, Jean-Pierre, Cupertino, CA, 95014 (US)
(74) Representative: Lang, Johannes

(56) References cited:
- US-A1- 2014 181 052
- US-A1- 2016 178 940
- US-A1- 2016 189 601
- US-B1- 9 311 735

## Description

### BACKGROUND

The present disclosure relates generally to electronic displays and, more particularly, to gain applied to display an image or image frame on an electronic display.

This section is intended to introduce the reader to various aspects of art that may be related to various aspects of the present techniques, which are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

Electronic devices often use electronic displays to provide visual representations of information by displaying one or more images. Such electronic devices may include computers, mobile phones, portable media devices, tablets, televisions, virtual-reality headsets, and vehicle dashboards, among many others. To display an image, an electronic display may control light emission from display pixels based at least in part on image data, which indicates target characteristics of the image. For example, image data may indicate target luminance of specific color components, such as a green component, a blue component, and/or a red component, at various points (e.g., image pixels) in the image.

Relying on blending (e.g., averaging) of the color components, the electronic display may enable perception of various colors in the image. For example, blending the green component, the blue component, and the red components at various luminance levels may enable perception of a range of colors from black to white. To facilitate controlling luminance of the color components, each display pixel in the electronic display may include one or more sub-pixels, which each controls luminance of one color component. For example, a display pixel may include a red sub-pixel, a blue sub-pixel, and/or a green sub-pixel.

In some instances, image data corresponding with an image to be displayed on an electronic display may be generated by an image data source. Since electronic displays often have a rectangular shape, the image data source may generate image data corresponding to a rectangular image. However, in some instances, an electronic display may be implemented with a non-rectangular display region. Nevertheless, to facilitate operational flexibility, the image data source may generate the image data, for example, with little or no consideration of display region shape implemented in an electronic display.

The prior art document US 2016 / 0 178 940 A1 relates to a color filter substrate and a display device. The prior art document US 2016 / 0 189 601 A1 relates to a display device which includes a data driver configured to receive data signals corresponding to an input image and to output a first data signal corresponding to a first portion of the input image to be displayed. The prior art document US 2014 / 0 181 052 A1 relates to techniques for aligned run-length encoding. The prior art document US 9,311,735 B1 relates to an image which is obtained at a computing device and an indication of a first one or more regions of the image to be filled based on values of pixels in a second one or more regions of the obtained image is obtained.

### SUMMARY

The present invention is defined in the independent claims. A preferred embodiment is provided by the dependent claim 3

The present disclosure generally relates to improving perceived image quality on an electronic display. To display an image, the electronic display controls light emission from its display pixels based at least in part on image data that indicates target characteristics (e.g., luminance) at image pixels in the image. **In** some instances, the image data is generated by an image data source.

Since electronic displays often have a rectangular display region, the image data source generates image data corresponding with a rectangular image. However, in some embodiments, the electronic display is implemented with a non-rectangular display region with one rounded (e.g. curved) border, or, for example, with more rounded (e.g., curved) borders. Thus, a display pipeline adjusts the rectangular image frame for display on the non-rectangular display region, by applying a black mask at pixel positions outside the display region. However, in some instances, merely applying a black mask results in perceivable visual artifacts, such as color fringing along a border of the display region and/or aliasing along a rounded border of the display region.

To facilitate improving perceived image quality, image data is processed based at least in part on gain values associated with a pixel position of each image pixel in the image. When a pixel position is within the display region, a corresponding display pixel is located at the pixel position. Since a display pixel includes multiple sub-pixels, a pixel position includes multiple sub-pixel positions each associated with a corresponding gain value.

In any case, the display pipeline applies programmable border gain values at pixel positions adjacent borders of the display region. By applying a corresponding programmable border gain value, display pixels adjacent a border are dimmed to reduce likelihood of producing perceivable color fringing along the border when the image is displayed.

Additionally or alternatively, the display pipeline determines gain values associated with pixel positions in anti-aliasing regions along rounded borders of the display region. A gain value associated with a pixel position located in an anti-aliasing region is determined based at least in part on distance between the pixel position and a corresponding rounded border. A gain value associated with the pixel position is inversely proportional to the shortest distance between a corresponding sub-pixel position and the rounded border. By applying such gain values, display pixels adjacent a rounded border are dimmed to reduce likelihood of producing perceivable aliasing along the rounded border when the image is displayed.

Gain values associated with each pixel position are indicated via a gain map. An uncompressed gain map explicitly associates (e.g., maps) each pixel position to a gain value set. As such, size of an uncompressed gain map is relatively large and, thus, stored in external memory.

However, in some instances, accessing the gain values from external memory affects processing efficiency and/or implementation associated cost, such as size (e.g., hardware footprint) of the display pipeline. To facilitate improving processing efficiency and/or reducing implementation associated cost, a compressed gain map is determined based on a corresponding uncompressed gain map. Due to compression, size of the compressed gain map is generally smaller, which enables storing the compressed gain map in internal memory of the display pipeline. Thus, accessing external memory to determine the gain values is obviated, thereby improving processing efficiency and/or reducing direct memory access implementation associated cost.

A compressed gain map includes a run map, a position map, and a gain value map. The run map indicates number of gain map rows of the uncompressed gain map included in each row run. Thus, to facilitate determining the run map, each gain map row is categorized as either a coded row or an uncoded row and one or more consecutive gain map rows with the same row categorization are grouped into a row run.

Additionally, the position map indicates pixel positions included in gain runs of each coded row. The pixel positions included in a gain run are indicated based at least in part on number of pixel positions in each gain run of a corresponding coded row. Thus, to facilitate determining the position map, each gain map entry in a coded row is categorized as a unity gain map entry, a zero gain map entry, or an intermediate gain map entry and one or more consecutive gain map entries with the same entry categorization are grouped into a gain run. To facilitate improving compression efficiency, the position map indicates pixel positions in a gain run relative to pixel positions in another gain run. Additionally, the position map is entropy encoded to facilitate further improving compression efficiency.

Furthermore, the gain value map indicates gain values associated with pixel positions in each intermediate gain run. To facilitate improving compression efficiency, the gain value map indicates a gain value associated with a pixel position relative to a gain value associated with another (e.g., neighbor) pixel position. Additionally, the gain value map is entropy encoded to facilitate further improving compression efficiency.

When indicated via a compressed gain map, the display pipeline reads the compressed gain map to determine gain values associated with each pixel position by decompressing into a corresponding uncompressed gain map. The display pipeline determines row categorization of a gain map row that includes a pixel position by reading the run map. Additionally, when the gain map row is categorized as an uncoded row, the display pipeline determines that a gain value associated with the pixel position is unity.

On the other hand, when the gain map row is categorized a coded row, the display pipeline determines pixel positions included in each gain run in the coded row by reading the position map. In other words, the display pipeline determines entry categorization of each gain map entry in the gain map row based at least in part on the position map. When entropy encoded, the display pipeline entropy decodes the position map.

When a gain map entry corresponding with the pixel position is categorized as a unity gain map entry, the display pipeline determines that the gain value associated with the pixel position is unity. Additionally, when the gain map entry corresponding with the pixel position is categorized as a zero gain map entry, the display pipeline determines that the gain value associated with the pixel position is zero. Furthermore, when the gain map entry corresponding with the pixel position is categorized as an intermediate gain map entry, the display pipeline determines the gain value associated with the pixel position by reading the gain value map. When entropy encoded, the display pipeline entropy decodes the gain value map.

As described above, a compressed gain map indicates gain values associated with a pixel position in a relative manner and/or relative another pixel position. The display pipeline experiences data dependencies when decompressing a compressed gain map, thereby limiting decompression efficiency (e.g., rate with which gain values associated with a pixel position are determined).

To facilitate improving decompression efficiency, pixel positions and associated gain values are grouped into multiple pixel regions, by dividing an uncompressed gain map into multiple uncompressed gain maps. By compressing each uncompressed gain map, multiple compressed gain maps each corresponding to one of the pixel regions are determined. In this manner, data dependencies between gain values associated with pixel positions in different pixel regions are reduced. In fact, implementing multiple compressed gain maps in this manner enables the display pipeline to vary order with which gain values are determined and, thus, access (e.g., fetch) pattern to the compressed gain maps. The display pipeline controls gain value determination order to improve memory access efficiency, by implementing a random access pattern.

### BRIEF DESCRIPTION OF THE DRAWINGS

Various aspects of this disclosure are better understood upon reading the following detailed description and upon reference to the drawings in which:
FIG. 1 is a block diagram of an electronic device including an electronic display to display images, in accordance with an embodiment;
FIG. 2 is an example of the electronic device of FIG. 1, in accordance with an embodiment;
FIG. 3 is another example of the electronic device of FIG. 1, in accordance with an embodiment;
FIG. 4 is another example of the electronic device of FIG. 1, in accordance with an embodiment;
FIG. 5 is another example of the electronic device of FIG. 1, in accordance with an embodiment;
FIG. 6 is a block diagram of a display pipeline implemented in the electronic device of FIG. 1, in accordance with an embodiment;
FIG. 7 is a flow diagram of a process for operating the display pipeline of FIG. 6, in accordance with an embodiment;
FIG. 8 is a block diagram of a sub-pixel layout resampler block and internal memory in the display pipeline of FIG. 6, in accordance with an embodiment;
FIG. 9 is a block diagram of a design device and the internal memory of FIG. 8, in accordance with an embodiment;
FIG. 10 is a flow diagram of a process for operating the design device of FIG. 10, in accordance with an embodiment;
FIG. 11 is a diagrammatic representation of a rectangular image frame, in accordance with an embodiment;
FIG. 12 a diagrammatic representation of image pixels in a top-left portion of the rectangular image frame of FIG. 11, in accordance with an embodiment;
FIG. 13 is an example of a display region with a non-rectangular shape, in accordance with an embodiment;

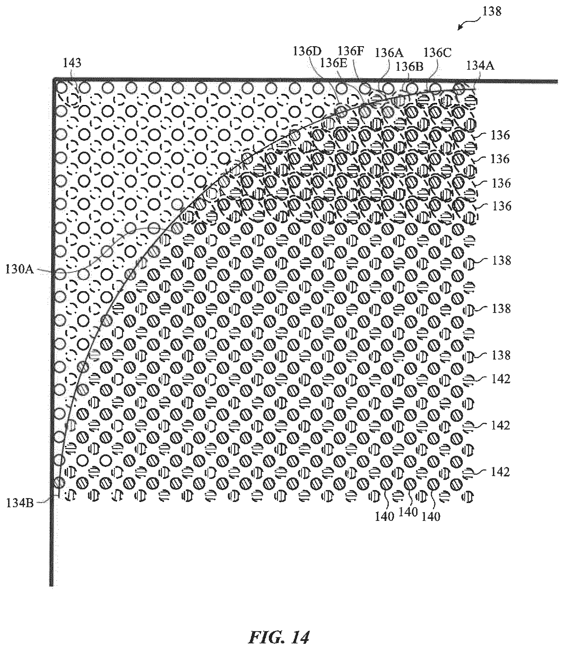

FIG. 14 is an example of display pixels in a top-left portion of the display region of FIG. 13 including a rounded border, in accordance with an embodiment;
FIG. 15 is a flow diagram of a process for determining gain values to be applied at sub-pixels along a rounded border, in accordance with an embodiment;
FIG. 16 is an example anti-aliasing region used to determine gain values to be applied along the rounded border of FIG. 14, in accordance with an embodiment;
FIG. 17 is another example anti-aliasing region used to determine gain values to be applied along the rounded border of FIG. 14, in accordance with an embodiment;
FIG. 18 is a diagrammatic representation of an uncompressed gain map, in accordance with an embodiment;
FIG. 19 is a flow diagram of a process for determining a compressed gain map, in accordance with an embodiment;
FIG. 20 is a flow diagram of a process for determining a run map included in the compressed gain map, in accordance with an embodiment;
FIG. 21 is a flow diagram of a process for determining a position map included in the compressed gain map, in accordance with an embodiment;
FIG. 22 is a flow diagram of a process for determining a gain value map included in the compressed gain map, in accordance with an embodiment;
FIG. 23 is a flow diagram of a process for operating the sub-pixel layout resampler block of FIG. 8, in accordance with an embodiment;
FIG. 24 is a flow diagram of a process for determining a gain value to be implemented by the sub-pixel layout resampler block of FIG. 8 from the compressed gain map, in accordance with an embodiment;
FIG. 25 is a flow diagram of a process for determining filter parameters to be implemented by the sub-pixel layout resampler block of FIG. 8, in accordance with an embodiment;
FIG. 26 is a flow diagram of a process for determining offset filter phase values based at least in part on a gain value to be applied at an offset sub-pixel, in accordance with an embodiment;
FIG. 27 is a flow diagram of a process for applying a gain value to determine display pixel image data, in accordance with an embodiment; and
FIG. 28 is a flow diagram of a process for upscaling display pixel image data, in accordance with an embodiment.

### DETAILED DESCRIPTION

One or more specific embodiments of the present disclosure will be described below. These described embodiments are only examples of the presently disclosed techniques. Additionally, in an effort to provide a concise description of these embodiments, all features of an actual implementation are not described in the specification. It should be appreciated that in the development of any such actual implementation, as in any engineering or design project, numerous implementation-specific decisions must be made to achieve the developers' specific goals, such as compliance with system-related and business-related constraints, which vary from one implementation to another. Moreover, it should be appreciated that such a development effort might be complex and time consuming, but is nevertheless a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there are additional elements other than the listed elements. Additionally, it should be understood that references to "one embodiment" or "an embodiment" of the present disclosure are not intended to be interpreted as excluding the existence of additional embodiments that also incorporate the recited features.

The present disclosure generally relates to electronic displays, which are used to present visual representations of information as images in one or more image frames. To display an image, an electronic display controls light emission from its display pixels based at least in part on image data that indicates target characteristics of the image. The image data indicates target luminance (e.g., brightness) of specific color components in a portion (e.g., image pixel) of the image, which when blended (e.g., averaged) together results in perception of a range of different colors.

Generally, each display pixel in the electronic display corresponds with an image pixel in an image to be displayed. In other words, a display pixel and an image pixel correspond to a pixel position. To facilitate displaying the image, a display pixel includes one or more sub-pixels, which each controls luminance of one color component at the pixel position. The display pixel includes a red sub-pixel that controls luminance of a red component, a green sub-pixel that control luminance of a green component, and/or a blue sub-pixel that controls luminance of a blue component.

However, different electronic displays implement different sub-pixel layouts. In some instances, the number of sub-pixels per display pixel in different electronic displays varies. In a first electronic display, each display pixel includes three sub-pixels. On the other hand, in a second electronic display, each display pixel includes two sub-pixels. Moreover, display pixels in other electronic displays include any suitable number of sub-pixels between one sub-pixel per display pixel to five or more sub-pixels per display pixel.

Additionally, in some instances, the color components of sub-pixels implemented in display pixels of different electronic displays vary. In the first electronic display, each display pixel includes a red sub-pixel, a green sub-pixel, and a blue sub-pixel. On the other hand, in the second electronic display, some (e.g., approximately half) of the display pixels each include a green sub-pixel and a red sub-pixel while the other display pixels each include a green sub-pixel and a blue sub-pixel. Moreover, display pixels in other electronic displays include any suitable combination of color component sub-pixels, with multiple sub-pixels of the same color component per display pixel.

Furthermore, in some instances, location of the sub-pixels within display pixels of different electronic displays varies. In the first electronic display, space (e.g., distance) between the sub-pixels is smaller. As such, perceivability of the space is lower and, thus, the sub-pixels in a display pixel are generally considered as co-located. On the other hand, in the second electronic display, space between the sub-pixels is larger due to each sub-pixel acting more like a point source. As such, perceivability of the space is higher and, thus, the sub-pixels in a display pixel of the second electronic display are generally considered as offset from one another. A display pixel in the second electronic display includes a first sub-pixel co-located with a corresponding image pixel and a second subpixel offset from the corresponding image pixel.

Moreover, in some instances, sub-pixels in different electronic displays are implemented to result in display regions with varying shapes. The first electronic display is implemented with a first display region that has rectangular shape. In other words, the first display region has four straight borders connected at approximately ninety degree corners. On the other hand, the second electronic display is implemented with a second a display region that has a non-rectangular shape. The second display region has four straight borders connected with four rounded (e.g., curved) borders.

In some instances, an image data source generates image data corresponding with image pixels of an image to be displayed. Since electronic displays often have a rectangular display region, the image data source generates image data corresponding with a rectangular image. As such, each image pixel in the rectangular image corresponds with a display pixel in the first electronic display since the first display region has a rectangular shape. In other words, each pixel position corresponds with both an image pixel and a display pixel.

However, since implemented with a non-rectangular shape, some image pixels in the rectangular image correspond to a pixel position outside the second display region of the second electronics display. When a top border of the rectangular image is aligned with a top border of the second display region and a left border of the rectangular image is aligned with a left border of the second display region, an image pixel at the top left corner of the rectangular image corresponds to a pixel position outside a top-left rounded border (e.g., corner) of the second display region.

Nevertheless, to improve operational flexibility, the image data source outputs the same image data with little or no consideration of an electronic display's sub-pixel layout. The image data source outputs image data corresponding with a rectangular image regardless of whether the image is to be displayed on the first electronic display or the second electronic display. However, in some instances, perceived image quality is affected by sub-pixel layout of an electronic display. The sub-pixel layout of the second electronic display results in perceivable color fringing along borders (e.g., top straight border, bottom straight border, left straight border, and/or right straight border) of the second display region. Additionally or alternatively, the sub-pixel layout of the second electronic display results in perceivable aliasing along rounded (e.g., top-left, top-right, bottom-left, and/or bottom-right) borders of the display region.

Accordingly, the present disclosure provides techniques for improving perceived image quality of an electronic display by processing image data based at least in part on sub-pixel layout of the electronic display. A display pipeline receives and processes image data generated by an image data source before a corresponding image is displayed on the electronic display. The display pipeline processes image data in a source (e.g., RGB) format to determine image data in a display (e.g., GR or GB) format. More specifically, the display pipeline determines display pixel image data (e.g., image data corresponding with a display pixel) by filtering (e.g., interpolating or sampling) and applying gain values to image pixel image data (e.g., image data corresponding with an image pixel).

The display pipeline determines the display pixel image data by filtering the image pixel image data based at least in part on surrounding image pixel image data. The display pipeline determines offset sub-pixel image data (e.g., image data corresponding with an offset sub-pixel) by applying a low pass filter that equally averages corresponding color component image data of surrounding image pixels. Since offset from the surrounding image pixels, determining the offset sub-pixel image data in this manner results in a more gradual luminance change.

However, due at least in part to sub-pixel layout of the electronic display, the more gradual luminance change, in some instances, results in perceivable visual artifacts, such as color fringing along a borders of a display region and/or aliasing along a rounded border of the display region. When display pixels have a co-located green sub-pixel, green color fringing is perceivable along a first (e.g., top or bottom) straight border of the display region. Additionally, when display pixels have alternatingly either an offset red sub-pixel or an offset blue sub-pixel, violet color fringing is perceivable along a second (e.g., left or right) straight border of the display region. Furthermore, when display pixels have an offset sub-pixel, aliasing (e.g., jaggedness) is perceivable along a rounded (e.g., top-left, top-right, bottom-left, or bottom-right) border of the display region.

To reduce likelihood of producing perceivable visual artifacts, the display pipeline determines display pixel image data by applying gain values after filtering image pixel image data to dim sub-pixels along borders of the display region. To reduce likelihood of producing perceivable color fringing, the display pipeline applies intermediate gain values (e.g., greater than zero and less than unity) to dim sub-pixels in display pixels along borders (e.g., straight borders) of the display region. Additionally, to reduce likelihood of producing perceivable aliasing, the display pipeline applies intermediate gain values to dim sub-pixels in display pixels along rounded borders of the display region.

The gain value to be applied at a sub-pixel in a display pixel along a rounded border is determined based at least in part on distance between the sub-pixel and the rounded border. An anti-aliasing region including sub-pixel positions along the rounded border is determined. Additionally, the gain value associated with each sub-pixel position in the anti-aliasing region is inversely proportional to the shortest distance between the sub-pixel position and the rounded border. By applying gain values determined in this manner, sub-pixels along the rounded border are linearly dimmed based at least in part on sub-pixel layout of the electronic display to reduce likelihood of producing perceivable aliasing along the rounded border.

Additionally, the gain value corresponding with pixel positions outside the display region of the electronic display and the anti-aliasing region is set to zero. By applying gain values determined in this manner, a black mask is applied to black out image data corresponding with pixel positions outside the display region. In this manner, a rectangular image is adjusted to facilitate display on an electronic display with a non-rectangular display region. To facilitate further improving perceived image quality, the display pipeline adaptively adjusts filtering parameters (e.g., filter phase or filter coefficients) applied to image pixel image data based at least in part on gain values associated with a corresponding pixel position and/or gain values associated with neighboring pixel positions.

The display pipeline calculates gain values associated with a pixel position while processing corresponding image pixel image data. Additionally, the gain value to be applied at display pixels along a border of the display region is stored in a programmable register. A first border gain value to be applied at display pixels along a top straight border is stored in a first programmable register, a second border gain value to be applied at display pixels along a bottom straight border is stored in a second programmable register, a third gain value to be applied at display pixels along a left straight border is stored in a third programmable register, and a fourth gain value to be applied at display pixels along a right straight border is stored in a fourth programmable register.

Furthermore, gain values associated with a pixel positon are predetermined since characteristics (e.g., resolution, sub-pixel layout, and/or display region shape) of electronic displays are generally fixed. A design device determines and stores the gain values as a gain map, which indicates a set of gain values associated with each pixel position. The gain value set associated with a pixel position includes a gain value for each color component in a corresponding display pixel. When the display pixel includes a red sub-pixel and a green sub-pixel, the gain value set associated with its pixel position includes a red gain value and a green gain value. Additionally, when the display pixel includes a blue sub-pixel and a green sub-pixel, the gain value set associated with its pixel position includes a blue gain value and a green gain value.

An uncompressed gain map explicitly associates (e.g., maps) each pixel position to a corresponding gain value set. In other words, number of entries in the uncompressed gain map is greater than or equal to resolution of the electronic display. As such, size (e.g., number of bits) of the uncompressed gain map is relatively large - particular as resolution of electronic displays continue to increase. To accommodate its size, the uncompressed gain map is stored in external memory and, thus, retrieved from the external memory by the display pipeline via a direct memory access (DMA) channel. However, accessing external memory via a direct memory access channel affects processing efficiency and/or implementation associated cost, such as power consumption and/or size (e.g., hardware footprint) of the display pipeline.

To facilitate improving processing efficiency and/or reducing implementation associated cost, a compressed gain map is used to indicate the gain values. The design device compresses an uncompressed gain map to determine a compressed gain map. Due to compression, size of the compressed gain map is generally smaller than the uncompressed gain map. The reduced size enables storing the compressed gain map in internal memory of the display pipeline. Thus, accessing external memory to determine the gain values is obviated, thereby improving processing efficiency and/or reducing direct memory access implementation associated cost.

To facilitate compression, each gain map row in the uncompressed gain map is categorized as either an uncoded row or a coded row based at least in part on gain values indicated by its corresponding gain map entries. The design device categorizes a gain map row as an uncoded row when each gain value indicated by the gain map row is unity. On the other hand, the design device categorizes a gain map row as a coded row when one or more gain value indicated by the gain map row is less than unity. In other words, a gain value in a coded row is zero, unity, or an intermediate gain value (e.g., greater than zero and less than unity).

Additionally, based on row categorization, each gain map row is grouped into a row run. The design device groups one or more consecutive coded rows into a coded row run. Additionally, the design device groups one or more consecutive uncoded rows into an uncoded row run. The row runs alternate between coded row runs and uncoded row runs.

Furthermore, gain map entries in each coded row are grouped into a gain run. The design device groups one or more consecutive gain map into an intermediate gain run when each gain map entry indicates at least one intermediate gain value. Additionally, the design device groups one or more consecutive gain map entries into a zero gain run when each gain value indicated by the gain map entries is zero. Furthermore, the design device groups one or more consecutive gain map entries into a unity gain run when each gain value indicated by the gain map entries is unity. The gain runs in a coded row alternate between position (e.g., zero or unity) gain runs and intermediate gain runs.

Additionally, a compressed gain map includes a run map, a position map, a gain value map, and one or more indicators stored in programmable registers of the internal memory. The run map indicates number of gain map rows in each row run and, thus, determined based at least in part on grouping of the gain map rows into row runs. Each run map entry explicitly indicates number of gain map rows in a corresponding row run. When a first row run includes the first ten gain map rows and a second row run includes the next five gain map rows, the design device indicates a value of ten in a first run map entry and a value of five in a second run map entry.

Additionally, a starting row run indicator indicates whether the first row run identified in the uncompressed gain map is a coded row run or an uncoded row run. When the first row run is an uncoded row run, the design device indicates a first value (e.g., 0 bit) in the starting row run indicator. On the other hand, when the first row run is a coded row run, the design device indicates a second value (e.g., 1 bit) in the starting row run indicator.

The position map indicates pixel positions associated with gain runs in each coded row. Each position map entry indicates the pixel positions associated with a gain run by explicitly indicating number of gain map entries included in the gain run. When a first gain run includes the first four gain map entries of a gain map row and a second gain run includes the next six gain map entries of the gain map row, the design device indicates a value of four in a first position map entry and a value of six in a second run map entry.

To facilitate improving compression efficiency, each position map entry indicates the pixel positions in a gain run relative to pixel positions in another gain run. When a first gain run includes the first four gain map entries of a first gain map row and a second gain run includes the first five gain map entries of a second gain map row, the design device determines a pixel position difference of positive one since the second gain run includes one more pixel position than the first gain run. To indicate the positive one position difference, the design device indicates a first value (e.g., 0 bit) in a first position map entry and a value of one in a second position map entry. Additionally, when a third gain run includes the next six gain map entries of the first gain map row and a fourth gain run includes the next five gain map entries of the second gain map row, the design device determines a pixel position different of negative one since the fourth gain run includes one less pixel position than the third gain run. To indicate the negative one position difference, the design device indicates a second value (e.g., 1 bit) in a third position map entry and a value of one in a fourth position map entry. The pixel position differences are entropy encoded to facilitate further improving compression efficiency.

The gain value map indicates gain values associated with pixel positions in each intermediate gain run. Gain value map entries explicitly indicate a gain value associated with a pixel position. When a display pixel includes a first (e.g., green) sub-pixel and a second (e.g., red or blue) sub-pixel, the design device explicitly indicates a first gain value associated with the first sub-pixel in a first gain value map entry and a second gain value associated with the second sub-pixel in a second gain value map entry. To facilitate improving compression efficiency, some gain value map entries indicate a gain value associated with a pixel position relative to a gain value associated with another pixel position. When a first gain value associated with a current pixel position is the same as a second gain value associated with a directly previous (e.g., left neighbor) pixel position, the design device indicates a first value (e.g., 1 bit) in a gain value map entry associated with the current pixel position. On the other hand, when the first gain value and the second gain value are different, the design device indicates a second value (e.g., 0 bit) in the gain map entry. Explicitly indicated gain values are entropy encoded to facilitate further improving compression efficiency.

As described above, the display pipeline processes image pixel image data based at least in part on gain values associated with a corresponding pixel position. Thus, when indicated using a compressed gain map, the display pipeline decompresses the compressed gain map to determine gain values (e.g., red gain value, blue gain value, and/or green gain value) associated with one or more pixel positions. The display pipeline reads the run map (e.g., via a bit stream) and/or a starting row run indicator to determine whether the image pixel image data corresponds to a pixel position in a coded row run or an uncoded row run. In this manner, the display pipeline determines whether the pixel position is in a coded row or an uncoded row.

As described above, a gain map row is categorized as an uncoded row when each of the gain values indicated by its gain map entries are equal to unity. Thus, when the display pipeline determines that a pixel position is in an uncoded row, the display pipeline determines that each gain value associated with the pixel position is equal to unity. Additionally, as described above, a gain map row is categorized as a coded row when one or more gain values indicated by its gain map entries are less than unity. Thus, when the display pipeline determines that a pixel position is in a coded row, the display pipeline reads the position map (e.g., via a bit stream) to determine whether the pixel position is in a position gain run or an intermediate gain run. Additionally, when indicated via entropy encoded pixel position differences, the display pipeline entropy decodes the position map to determine a pixel position difference and determine pixel positions in a gain run by applying the pixel position difference relative to another gain run in a top neighbor gain map row.

As described above, one or more consecutive gain map entries are categorized as an intermediate gain run when each gain map entry includes at least one intermediate gain value (e.g., greater than zero and less than unity). Thus, when the display pipeline determines that a pixel position is in an intermediate gain run, the display pipeline reads the gain value map (e.g., via a bit stream) to determine a gain value set associated with the pixel position. Additionally, when a gain value is entropy encoded, the display pipeline entropy decodes the gain value map to determine the gain value associated with the pixel position.

As described above, a position gain run is either a zero gain run or a unity gain run. Thus, when the display pipeline determines that a pixel position is in a position gain run, the display pipeline reads a corresponding position gain value indicator to determine whether the pixel position is in a zero gain run or a unity gain run. Additionally, as described above, one or more consecutive gain map entries are categorized as a zero gain run when each included gain value is zero. Thus, when a corresponding position gain value indicator indicates that a pixel position is in a zero gain run, the display pipeline determines that each gain value associated with the pixel position is equal to zero. Furthermore, as described above, one or more consecutive gain map entries are categorized as a unity gain run when each included gain value is unity. Thus, when a corresponding position gain value indicator indicates that a pixel position is in a unity gain run, the display pipeline determines that each gain value associated with the pixel position is equal to unity.

Based at least in part on the gain values, the display pipeline processes image pixel image data to determine display pixel image data, which is used to display a corresponding image on an electronic display. By applying the gain values, the display pipeline applies a black mask that adjusts a rectangular image for display on a non-rectangular display region. Additionally, the display pipeline adaptively (e.g., dynamically) adjusts filter parameters based at least in part on the gain values to improve sharpness along edges (e.g., sharp gradient transitions) in an image. Furthermore, by applying the gain values, the display pipeline dims display pixels along a display region border to reduce likelihood of producing perceivable visual artifacts (e.g., aliasing and/or fringing) along the display region border. In this manner, the display pipeline processes image data based at least in part on the gain values determined from a (e.g., compressed or uncompressed) gain map before a corresponding image is displayed on an electronic display to improve perceived image quality of the electronic display.

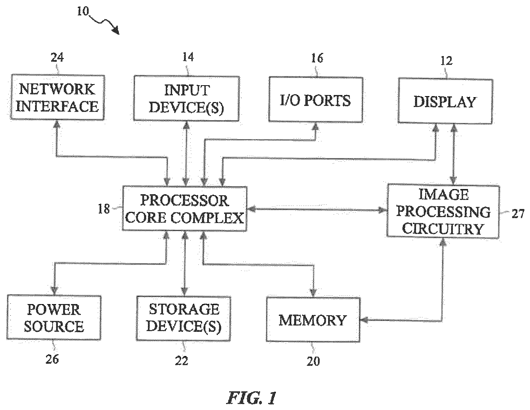

To help illustrate, one embodiment of an electronic device 10 that utilizes an electronic display 12 is shown in FIG. 1. As will be described in more detail below, the electronic device 10 is any suitable electronic device, such as a handheld electronic device, a tablet electronic device, a notebook computer, and the like. Thus, it should be noted that FIG. 1 is merely one example of a particular implementation and is intended to illustrate the types of components that are present in the electronic device 10.

In the depicted embodiment, the electronic device 10 includes the electronic display 12, input devices 14, input/output (I/O) ports 16, a processor core complex 18 having one or more processor(s) or processor cores, local memory 20, a main memory storage device 22, a network interface 24, a power source 26, and image processing circuitry 27. The various components described in FIG. 1 include hardware elements (e.g., circuitry), software elements (e.g., a tangible, non-transitory computer-readable medium storing instructions), or a combination of both hardware and software elements. It should be noted that the various depicted components are combined into fewer components or separated into additional components. The local memory 20 and the main memory storage device 22 are included in a single component. Additionally, the image processing circuitry 27 (e.g., a graphics processing unit) is included in the processor core complex 18.

As depicted, the processor core complex 18 is operably coupled with local memory 20 and the main memory storage device 22. The local memory 20 and/or the main memory storage device 22 are tangible, non-transitory, computer-readable media that store instructions executable by the processor core complex 18 and/or data to be processed by the processor core complex 18. The local memory 20 includes random access memory (RAM) and the main memory storage device 22 includes read only memory (ROM), rewritable non-volatile memory such as flash memory, hard drives, optical discs, and the like.

The processor core complex 18 executes instructions stored in local memory 20 and/or the main memory storage device 22 to perform operations, such as generating source image data. As such, the processor core complex 18 includes one or more general purpose microprocessors, one or more application specific processors (ASICs), one or more field programmable logic arrays (FPGAs), or any combination thereof.

As depicted, the processor core complex 18 is also operably coupled with the network interface 24. Using the network interface 24, the electronic device 10 is communicatively coupled to a network and/or other electronic devices. The network interface 24 connects the electronic device 10 to a personal area network (PAN), such as a Bluetooth network, a local area network (LAN), such as an 802.11x Wi-Fi network, and/or a wide area network (WAN), such as a 4G or LTE cellular network. In this manner, the network interface 24 enables the electronic device 10 to transmit image data to a network and/or receive image data from the network.

Additionally, as depicted, the processor core complex 18 is operably coupled to the power source 26. The power source 26 provides electrical power to operate the processor core complex 18 and/or other components in the electronic device 10. Thus, the power source 26 includes any suitable source of energy, such as a rechargeable lithium polymer (Li-poly) battery and/or an alternating current (AC) power converter.

Furthermore, as depicted, the processor core complex 18 is operably coupled with I/O ports 16 and the input devices 14. The I/O ports 16 enable the electronic device 10 to interface with various other electronic devices. Additionally, the input devices 14 enable a user to interact with the electronic device 10. The input devices 14 include buttons, keyboards, mice, trackpads, and the like. Additionally or alternatively, the electronic display 12 includes touch sensing components that enable user inputs to the electronic device 10 by detecting occurrence and/or position of an object touching its screen (e.g., surface of the electronic display 12).

In addition to enabling user inputs, the electronic display 12 facilitates providing visual representations of information by displaying images (e.g., in one or more image frames). The electronic display 12 displays a graphical user interface (GUI) of an operating system, an application interface, text, a still image, or video content. To facilitate displaying images, the electronic display 12 includes a display panel with one or more display pixels. Additionally, each display pixel includes one or more sub-pixels, which each control luminance of one color component (e.g., red, blue, or green).

As described above, the electronic display 12 displays an image by controlling luminance of the sub-pixels based at least in part on corresponding image data (e.g., image pixel image data and/or display pixel image data). The image data is received from another electronic device via the network interface 24 and/or the I/O ports 16. Additionally or alternatively, the image data is generated by the processor core complex 18 and/or the image processing circuitry 27.

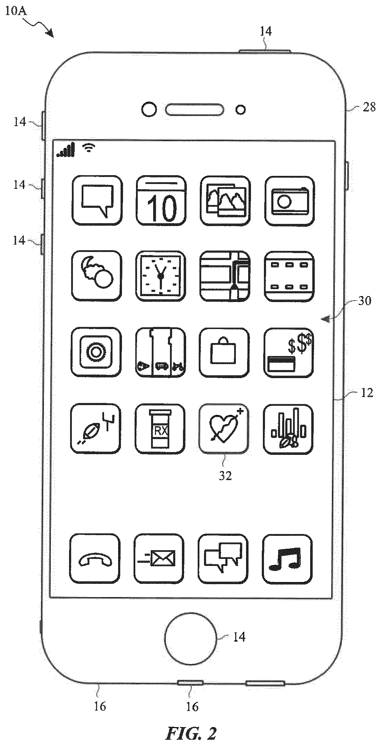

As described above, the electronic device 10 is any suitable electronic device. To help illustrate, one example of a suitable electronic device 10, specifically a handheld device 10A, is shown in FIG. 2. The handheld device 10A is a portable phone, a media player, a personal data organizer, a handheld game platform, and/or the like. The handheld device 10A is a smart phone, such as any iPhone^{®} model available from Apple Inc.

As depicted, the handheld device 10A includes an enclosure 28 (e.g., housing). The enclosure 28 protects interior components from physical damage and/or shields them from electromagnetic interference. Additionally, as depicted, the enclosure 28 surrounds the electronic display 12. In the depicted embodiment, the electronic display 12 is displaying a graphical user interface (GUI) 30 having an array of icons 32. When an icon 32 is selected either by an input device 14 or a touch-sensing component of the electronic display 12, an application program launches.

Furthermore, as depicted, input devices 14 open through the enclosure 28. As described above, the input devices 14 enable a user to interact with the handheld device 10A. The input devices 14 enable the user to activate or deactivate the handheld device 10A, navigate a user interface to a home screen, navigate a user interface to a user-configurable application screen, activate a voice-recognition feature, provide volume control, and/or toggle between vibrate and ring modes. As depicted, the I/O ports 16 also open through the enclosure 28. The I/O ports 16 include an audio jack to connect to external devices.

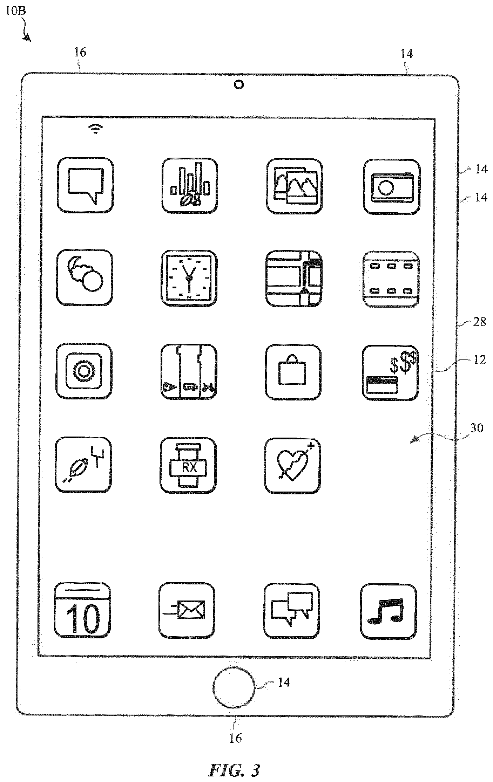

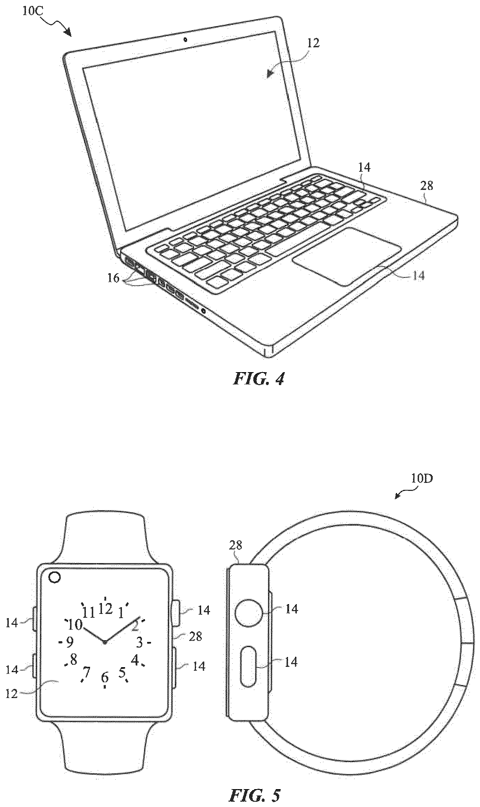

To further illustrate, another example of a suitable electronic device 10, specifically a tablet device 10B, is shown in FIG. 3. For illustrative purposes, the tablet device 10B is any iPad^{®} model available from Apple Inc. A further example of a suitable electronic device 10, specifically a computer 10C, is shown in FIG. 4. For illustrative purposes, the computer 10C is any Macbook^{®} or iMac^{®} model available from Apple Inc. Another example of a suitable electronic device 10, specifically a watch 10D, is shown in FIG. 5. For illustrative purposes, the watch 10D is any Apple Watch^{®} model available from Apple Inc. As depicted, the tablet device 10B, the computer 10C, and the watch 10D each also includes an electronic display 12, input devices 14, I/O ports 16, and an enclosure 28.

As described above, the electronic display 12 displays images based at least in part on image data received from the processor core complex 18 and/or the image processing circuitry 27. Additionally, as described above, the image data is processed before being used to display an image on the electronic display 12. A display pipeline processes the image data, based on gain values associated with corresponding pixel position to facilitate improving perceived image quality of the electronic display 12.

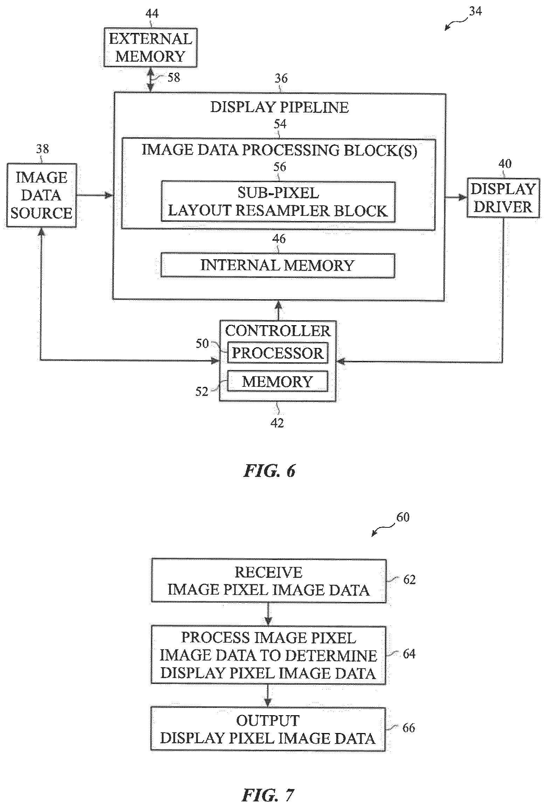

To help illustrate, a portion 34 of the electronic device 10 including a display pipeline 36 is shown in FIG. 6. The display pipeline 36 is implemented by circuitry in the electronic device 10, circuitry in the electronic display 12, or a combination thereof. The display pipeline 36 is included in the processor core complex 18, the image processing circuitry 27, a timing controller (TCON) in the electronic display 12, or any combination thereof.

As depicted, the portion 34 of the electronic device 10 also includes an image data source 38, a display driver 40, a controller 42, and external memory 44. The controller 42 controls operation of the display pipeline 36, the image data source 38, and/or the display driver 40. To facilitate controlling operation, the controller 42 includes a controller processor 50 and controller memory 52. The controller processor 50 executes instructions stored in the controller memory 52. Thus, the controller processor 50 is included in the processor core complex 18, the image processing circuitry 27, a timing controller in the electronic display 12, a separate processing module, or any combination thereof. Additionally, the controller memory 52 is included in the local memory 20, the main memory storage device 22, the external memory 44, internal memory 46 of the display pipeline 36, a separate tangible, non-transitory, computer readable medium, or any combination thereof.

In the depicted embodiment, the display pipeline 36 is communicatively coupled to the image data source 38. In this manner, the display pipeline 36 receives image data corresponding with an image to be displayed on the electronic display 12 from the image data source 38in a source (e.g., RGB) format and/or as a rectangular image. The image data source 38 is included in the processor core complex 18, the image processing circuitry 27, or a combination thereof.

As described above, the display pipeline 36 processes the image data received from the image data source 38. To process the image data, the display pipeline 36 includes one or more image data processing blocks 54. In the depicted embodiment, the image data processing blocks 54 include a sub-pixel layout resampler (SPLR) block 56. The image data processing blocks 54 additionally or alternatively include an ambient adaptive pixel (AAP) block, a dynamic pixel backlight (DPB) block, a white point correction (WPC) block, a sub-pixel layout compensation (SPLC) block, a burn-in compensation (BIC) block, a panel response correction (PRC) block, a dithering block, a sub-pixel uniformity compensation (SPUC) block, a content frame dependent duration (CDFD) block, an ambient light sensing (ALS) block, or any combination thereof.

As will be described in more detail below, the display pipeline 36 processes the image data received from the image data source 38 based at least in part on data stored in the external memory 44 and/or the internal memory 46. Generally, storing data in the external memory 44 versus the internal memory 46 presents various implementation associated cost and/or processing efficiency tradeoffs. Due at least in part to physical sizing constraints, increasing storage capacity of the external memory 44 is easier than increasing storage capacity of the internal memory 46. As such, storage capacity of the external memory 44 is generally larger than storage capacity of the internal memory 46.

Additionally, access to the external memory 44 and the internal memory 46 differs. The internal memory 46 is dedicated for use by the display pipeline 36. In other words, data stored the internal memory 46 more readily accessible by the display pipeline 36 with reduced latency, which facilitates improving processing efficiency of the display pipeline 36. Comparatively, since external from the display pipeline 36, the display pipeline 36 accesses the external memory 44 via a direct memory access (DMA) channel 58. However, to provide data access in this manner, the direct memory access channel 58 is implemented with increased bandwidth, which increases implementation associated cost. Moreover, when the external memory 44 is shared with other components, data access latency and, thus, processing efficiency of the display pipeline 36 is affected.

After processing, the display pipeline 36 outputs processed image data, such as display pixel image data, to the display driver 40. Based at least in part on the processed image data, the display driver 40 applies analog electrical signals to the display pixels of the electronic display 12 to display images in one or more image frames. In this manner, the display pipeline 36 operates to facilitate providing visual representations of information on the electronic display 12.

To help illustrate, one embodiment of a process 60 for operating the display pipeline 36 is described in FIG. 7. Generally, the process 60 includes receiving image pixel image data (process block 62), processing the image pixel image data to determine display pixel image data (process block 64), and outputting the display pixel image data (process block 66). The process 60 is implemented based on circuit connections formed in the display pipeline 36. Additionally or alternatively, the process 60 is implemented by executing instructions stored in a tangible non-transitory computer-readable medium, such as the controller memory 52, using processing circuitry, such as the controller processor 50.

As described above, the display pipeline 36 receives image pixel image data, which indicates target luminance of color components at points (e.g., image pixels) in an image, from the image data source 38 (process block 62). The image pixel image data corresponds to a rectangular image. Additionally, the image pixel image data is in a source format. When the source format is an RGB format, image pixel image data indicates target luminance of a red component, target luminance of a blue component, and target luminance of a green component at a corresponding pixel position.

Additionally, the controller 42 instructs the display pipeline 36 to process the image pixel image data to determine display pixel image data, which indicates target luminance of color components at display pixels of the electronic display 12, (process block 64) and output the display pixel image data to the display driver 40 (process block 66). To determine the display pixel image data, the display pipeline 36 converts image data from a source format to a display format. The display pipeline 36 determines the display format based at least in part on layout of sub-pixels in the electronic display 12. When some display pixels include green and red sub-pixels while other display pixels include green and blue sub-pixels, the display format is a green-red and green-blue (GRGB) format.

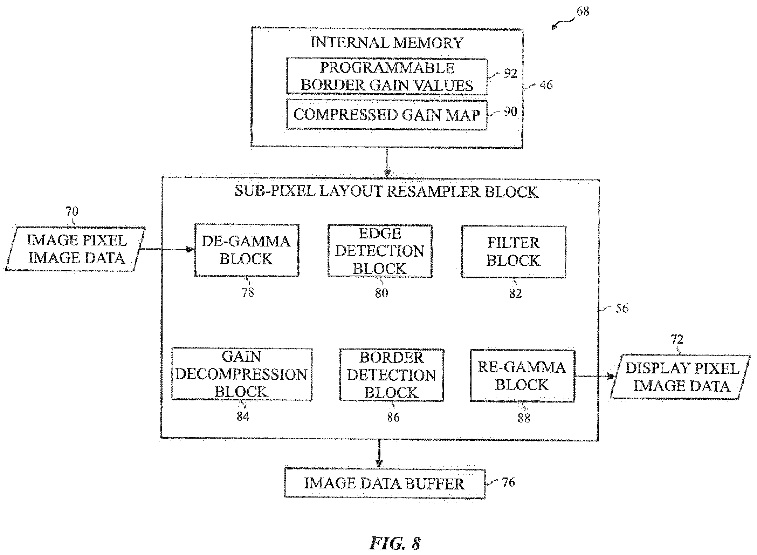

To help illustrate, a portion 68 of the display pipeline 36 including the sub-pixel layout resampler block 56 is shown in FIG. 8. As depicted, the sub-pixel layout resampler block 56 receives image pixel image data 70 corresponding with a current image pixel and outputs display pixel image data 72 corresponding with a current display pixel. The sub-pixel layout resampler block 56 receives the image pixel image data 70 from another image data processing block 54 and/or from the image data source 38. Additionally, the sub-pixel layout resampler block 56 outputs the display pixel image data 72 to another image data processing block 54 and/or the display driver 40.

To facilitate generating the display pixel image data 72, the sub-pixel layout resampler block 56 includes a de-gamma block 78, an edge detection block 80, a filter block 82, a gain decompression block 84, a border detection block 86, and a re-gamma block 88. The image pixel image data 70 is in a gamma (e.g., non-linear) domain. To facilitate subsequent processing, the de-gamma block 78 converts the image pixel image data 70 to a linear domain.

Additionally, the edge detection block 80 determines edge parameters, such as likelihood of an edge occurring at an offset sub-pixel of the current display pixel and/or expected direction of the edge at the offset sub-pixel. The edge detection block 80 determines edge parameters based at least in part on characteristics of the offset sub-pixel, such as gradient of the area around the offset sub-pixel. To facilitate determining the characteristics, the edge detection block 80 determines statistics indicative of the characteristics. The edge detection block 80 determines difference metrics (e.g., sum-of-absolute difference) between image pixel blocks around the offset sub-pixel, which are indicative of gradient around the offset sub-pixel and, thus, used to determine the edge parameters.

An image data buffer 76 stores image data corresponding with other image pixels at pixel positions neighboring the current image pixel. In other words, the frame buffer stores image data corresponding with the image pixel blocks around the offset sub-pixel. Thus, to facilitate determining the edge parameters, the sub-pixel layout resampler block 56 is communicatively coupled to the image data buffer 76.

Furthermore, the filter block 82 converts the image pixel image data from the source (e.g., RGB) format to the display (e.g., GRGB) format based at least in part on the edge parameters. To convert into the display format, the filter block 82 determines and applies filter parameters to the image pixel image data 70. The filter block 82 filters (e.g., samples) the image pixel image data 70 in the RGB to generate display pixel image data 72 in the green-red (GR) or the green-blue (GB) format. In other words, the filter block 82 determines image data corresponding with the offset sub-pixel and image data corresponding with a co-located sub-pixel of the current display pixel.

The filter block 82 determines the filter parameters to be applied to the image pixel image data 70 based at least in part on gain values associated with a current pixel position of the current image pixel. Additionally, after filtering, the filter block 82 applies the gain values associated with the current pixel position to the display pixel image data 72. The display pipeline 36 algorithmically calculates the gain values associated with a pixel position.

Additionally or alternatively, the gain values are predetermined and stored via a gain map. An uncompressed gain map explicitly associates (e.g., maps) each pixel position with a set of gain values. The set of gain values associated with a pixel position includes one gain value for each sub-pixel of a display pixel at the pixel position. When a display pixel includes a red sub-pixel, a blue sub-pixel, and a green sub-pixel, the set of gain values associated with its pixel position includes a red gain value, a blue gain value, and a green gain value. Additionally, when a display pixel includes a green sub-pixel and a red sub-pixel, the set of gain values associated with its pixel position includes a red gain value and a green gain value. Furthermore, when a display pixel includes a green sub-pixel and a blue sub-pixel, the set of gain values associated with its pixel position includes a blue gain value and a green gain value.

Since an uncompressed gain map associates a gain value set with at least pixel positions corresponding to each display pixel, size of an uncompressed gain map varies based on resolution of the electronic display 12. In other words, size of an uncompressed gain map is relatively large - particularly as resolution of electronic displays continue to increase. Thus, an uncompressed gain map is stored in the external memory 44 and accessed via the direct memory access channel 58.

However, as described above, providing the display pipeline 36 access to the external memory 44 affects implementation associated cost and/or processing efficiency. Thus, data indicative of the gain values associated with each pixel position is stored in the internal memory 46. In the depicted embodiment, the internal memory 46 stores a compressed gain map 90, which is determined by compressing a corresponding uncompressed gain map, and one or more programmable border gain value indicators 92, which each indicate a gain value to be applied at display pixels along a corresponding (e.g., top, bottom, left, or right) display region border.

Thus, to facilitate determining gain values associated with the current pixel position, the gain decompression block 84 decompresses the compressed gain map 90. Additionally, the border detection block 86 determines whether the current display pixel is along a border of the display region and determines a corresponding one of the programmable border gain value indicators 92 when the current display pixel is along the border. As described above, based at least in part on the gain values, the sub-pixel layout resampler block 56 processes the image pixel image data 70 to determine display pixel image data 72. Since determined in the linear domain, the re-gamma block 88 converts the display pixel image data 72 to the gamma domain. Additionally, since in the display format, the sub-pixel layout resampler block 56 upscales the display pixel image data 72 to the source format.

Thus, to facilitate determining the display pixel image data 72, the compressed gain map 90 and the programmable border gain value indicators 92 are determined and stored in the internal memory 46. A design device determines the compressed gain map 90 based at least in part on a corresponding uncompressed gain map. Additionally, the design device stores the compressed gain map 90 and the programmable border gain value indicators 92 in the internal memory 46 before deployment of the display pipeline 36 and/or the electronic display 12.

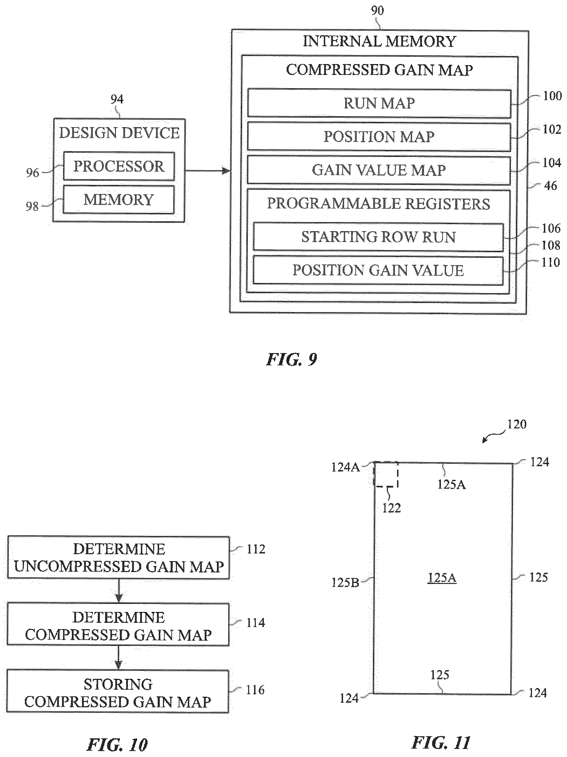

To help illustrate, one embodiment of a design device 94 communicatively coupled to the internal memory 46 is shown in FIG. 9. Additionally, one example of a compressed gain map 90 is stored in the internal memory 46. It should be appreciated that the example compressed gain map 90 is merely intended to be illustrative and not limiting. In other words, compressed gain maps 90 in other embodiments vary based on compression technique implemented by the design device 94.

As described above, the design device 94 determines and stores the compressed gain map 90 in the internal memory 46. To facilitate determining the compressed gain map 90, the design device 94 includes a device processor 96 and device memory 98. The device processor 96 executes instructions stored in the device memory 98. Thus, the device processor 96 is included in the processor core complex 18, the image processing circuitry 27, a timing controller in the electronic display 12, the controller processor 50, a separate processing module, or any combination thereof. Additionally, the device memory 98 is included in the local memory 20, the main memory storage device 22, the external memory 44, the internal memory 46, the controller memory 52, a separate tangible, non-transitory, computer readable medium, or any combination thereof.

In the depicted embodiment, the compressed gain map 90 includes a run map 100, a position map 102, a gain value map 104, and one or more indicators, which are stored in programmable registers 106 of the internal memory 46. The run map 100 indicates number of gain map rows and, thus, pixel position rows included in each row run. As will be described in more detail below, one or more consecutive gain map rows, which each include only unity gain values, are grouped into an uncoded row run. Additionally, one or more consecutive gain map rows, which each include at least one intermediate gain value or zero gain value, are grouped into a coded row run. Thus, as will be described in more detail below, a row run that includes a pixel position is determined based at least in part on the run map 100.

A starting row run indicator 108 indicates whether a row run is a coded row run or an uncoded row run. A starting row run indicator 108 of zero indicates that the row run is a coded run and a starting row run indicator 108 of unity indicates that the row run is an uncoded run or vice versa. A starting row run indicator 108 is associated with each row run to explicitly indicate categorization of a corresponding row run. To facilitate reducing size of the compressed gain map 90, a starting row run indicator 108 is only associated with a first (e.g., top) row run when the row runs alternate between coded row runs and uncoded row runs. Accordingly, as will be described in more detail below, categorization of a row run and, thus, a gain map row that includes a pixel position is determined based at least in part on the run map 100 and the starting row run indicator 108.

Additionally, the position map 102 indicates pixel positions included in gain runs of each coded row. As will be described in more detail below, one or more consecutive gain map entries, which each include at least one intermediate (e.g., between zero and unity) gain value, are grouped into an intermediate gain run. Additionally, one or more consecutive gain map entries, which each only include zero gain values or only unity gain values, are grouped into a position gain run. In other words, a position gain run is a zero gain run or a unity gain run.

To facilitate determining pixel positions included in a gain run, the position map 102 indicates number of pixel positions included in the gain run. Additionally, a coded row alternates between position gain runs and intermediate gain runs. Furthermore, the position map 102 indicates pixel positions included in a first gain run relative to pixel positions included in a second gain run. Thus, as will be described in more detail below, a gain run that includes a pixel position is determined based at least in part on the position map 100.

A position gain value indicator 110 indicates gain values associated with each pixel position in a corresponding position run. A position gain value indicator 110 of zero indicates that each (e.g., red, green, and/or blue) gain value associated with a pixel position in the corresponding position run is zero. Additionally, a position gain value indicator 110 of unity indicates that each gain value associated with a pixel position in the corresponding position run is unity. A position gain value indicator 110 is associated with each position run. Thus, as will be described in more detail below, gain values associated with a pixel position in a position run are determined based at least in part on a corresponding position gain value indicator 110.

Furthermore, the gain value map 104 indicates gain values associated with pixel positions in each intermediate gain run. A gain value set associated with a pixel position includes one gain value per sub-pixel of a display pixel at the pixel position. When a display pixel at a pixel position in an intermediate gain run includes three sub-pixels, the gain value map 104 associates the pixel position with three gain values. Additionally, when a display pixel at a pixel position in an intermediate gain run includes a co-located sub-pixel and an offset sub-pixel, the gain value map 104 associates the pixel position with a co-located gain value and an offset gain value.

Additionally or alternatively, a gain value set associated with a pixel position includes one gain value per color component of a display pixel at the pixel position. When a display pixel at a pixel position in an intermediate gain run includes a red sub-pixel and a green sub-pixel, the gain value map 104 associates the pixel position with a red gain value and a green sub-pixel. Additionally, when a display pixel at a pixel position in an intermediate gain run includes a blue sub-pixel and a green sub-pixel, the gain value map 104 associates the pixel position with a blue gain value and a green sub-pixel. Thus, as will be described in more detail below, gain values associated with pixel positions in intermediate gain runs are determined based at least in part on the gain value map 104.

One embodiment of a process 112 for operating the design device 94 is described in FIG. 10. Generally, the process 112 includes determining an uncompressed gain map (process block 114), determining a compressed gain map (process block 116), and storing the compressed gain map (process block 118). The process 112 is implemented by executing instructions stored in a tangible non-transitory computer-readable medium, such as the device memory 98, using processing circuitry, such as the device processor 96.

Accordingly, the design device 94 determines an uncompressed gain map (process block 114). As described above, an uncompressed gain map explicitly associates (e.g., maps) each pixel position to a gain value set. Additionally, the uncompressed gain map is determined based at least in part on sub-pixel layout of the electronic display 12, shape of an image corresponding with image pixel image data 70 received from the image data source 38, and/or display region shape of the electronic display 12.

To help illustrate, an example rectangular image frame 120 is shown in FIG. 11. As depicted, the rectangular image frame 120 includes four straight borders 125 connected by four ninety degree corners 124. The rectangular image frame 120 a top straight border 125A and a left straight border 125B connected at a top left ninety degree corner 124A. To display the rectangular image frame 120, the display pipeline 36 receives image pixel image data 70 corresponding with each image pixel in the rectangular image frame 120.

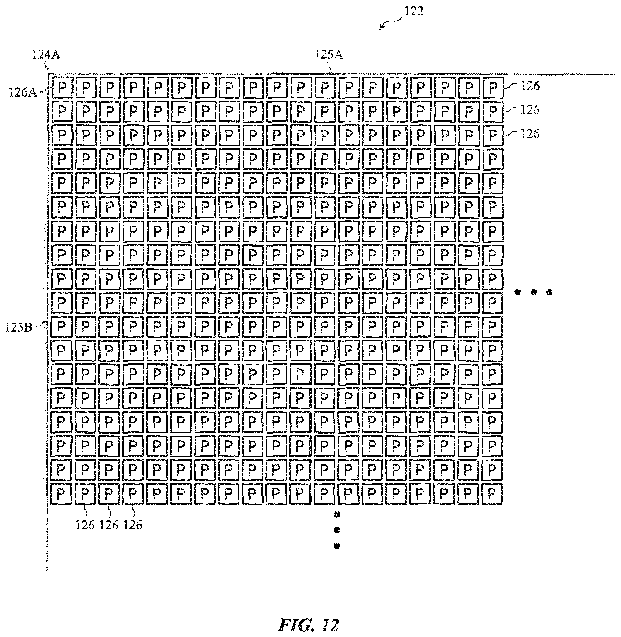

To help illustrate, image pixels 126 in a top left portion 122 of the rectangular image frame 120 are shown in FIG. 12. In the depicted embodiment, each image pixel 126 corresponds to a pixel position. As described above, image pixel image data 70 corresponding with an image pixel 126 indicates target luminance at a pixel position in an image. Image pixel image data 70 corresponding with a first image pixel 126A indicates target luminance of a red component, target luminance of a blue component, and target luminance of a green component at a first pixel position.

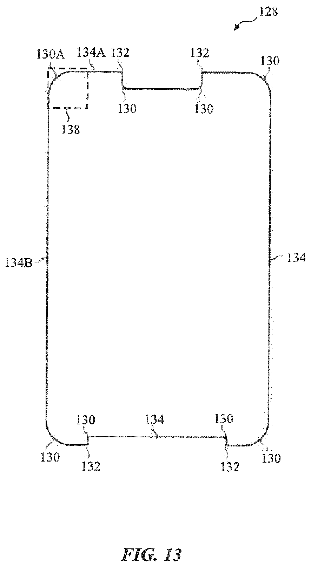

However, as described above, different electronic displays 12 have differing display region shapes. To help illustrate, an example of a non-rectangular display region 128 is shown in FIG. 13. It should be appreciated that the depicted display region is merely intended to be illustrative and not limiting. In other words, non-rectangular display regions implemented in other electronic displays 12 vary in shape. An electronic display 12 is implemented with a circular (e.g., non-rectangular) display region.

As depicted, the non-rectangular display region 128 includes multiple straight borders 134 connect by rounded (e.g., curved) borders 130. The non-rectangular display region 128 includes a top straight border 134A and a left straight border 134B connected via a top-left rounded border 130A. The non-rectangular display region 128 nevertheless includes one or more ninety-degree corners 132.

As described above, the electronic display 12 displays an image based on corresponding image data. The electronic display 12 displays an image by controlling luminance of its display pixels based on display pixel image data 72 generated by processing image pixel image data 70. Thus, the non-rectangular display region 128 is defined by pixel positions corresponding to display pixels implemented in the electronic display 12.

To help illustrate, display pixels 136 in a top-left portion 138 of the non-rectangular display region 128 are shown in FIG. 13. It should be appreciated that the depicted display pixels 136 are merely intended to be illustrative and not limiting. In other words, display pixels 136 in other electronic displays 12 are implemented with varying sub-pixel layouts.

In the depicted embodiment, the display pixels 136 are organized in rows and columns. A first display pixel row includes a first display pixel 136A, a second display pixel 136B, a third display pixel 136C, and so on. Additionally, a second display pixel row includes a fourth display pixel 136D, a fifth display pixel 136E, a sixth display pixel 136F, and so on.

As described above, a display pixel 136 includes one or more sub-pixels, which each control luminance of a corresponding color component. In the depicted embodiment, the display pixels 136 includes red sub-pixels 138, green sub-pixels 140, and blue sub-pixels 142. Additionally, in the depicted embodiment, display pixels 136 fully contained in the non-rectangular display region 128 each include two sub-pixels - namely a green sub-pixel 140 and alternatingly a red sub-pixel 138 or a blue sub-pixel 142. Along the second display pixel row, the fourth display pixel 136D includes a blue sub-pixel 142 and a green sub-pixel 140, the fifth display pixel 136E includes a red sub-pixel 138 and a green sub-pixel 140, the sixth display pixel 136F includes a red sub-pixel 138 and a green sub-pixel 140, and so on.

To implement the non-rectangular display region 128, some display pixels 136 along a rounded border 130 each include fewer sub-pixels. In the depicted embodiment, such display pixels 136 each include one sub-pixel - namely alternatingly a red sub-pixel 138 or a blue sub-pixel 142. Due to the top-left rounded border 130A, the first display pixel 136A includes only a blue sub-pixel 142, the second display pixel 136B includes only a red sub-pixel 138, and the third display pixel 136C includes only a blue sub-pixel 142.

In any case, as described above, each display pixel 136 corresponds with a pixel position and, thus, an image pixel received from the image data source 38. With regard to the depicted embodiment, each display pixel 136 corresponds with an image pixel 126 co-located with its green sub-pixel 140 or where a corresponding green sub-pixel 140 would otherwise be located. In other words, the green sub-pixels 140 are co-located sub-pixels, whereas the red sub-pixels 138 and the blue sub-pixels 142 are offset sub-pixels. Additionally, in the depicted embodiment, the offset sub-pixel (e.g., red sub-pixel 138 or blue sub-pixel 142) is offset to the bottom-right of the co-located sub-pixel (e.g., green sub-pixel 140). The offset sub-pixel is offset to the top-right, top-left, or bottom-left of the co-located sub-pixel.

To display an image frame, luminance of each display pixel 136 is controlled based at least in part on an image pixel image data 70 corresponding with an image pixel 126 at its pixel position. However, in some instances, shape of the image frame differs from display region shape of the electronic display 12. In such instances, one or more image pixels 126 correspond to pixel positions outside the display region. The first image pixel 126A in the rectangular image frame 120 corresponds to a pixel position 143, which is outside the non-rectangular display region 128. In other words, a display pixel 136 is not implemented in the electronic display 12 at a pixel position corresponding with an image pixel 126.

Thus, to facilitate displaying an image frame on a display region with a different shape, the image frame is adjusted before display, by applying a black mask. However, as described above, display pixels 136 rely on color blending to enable perception of a range of different colors. In other words, simply disregarding image pixels corresponding to a pixel positions outside the display region results in perceivable aliasing at a display pixel 136 along a rounded border 130 since neighboring display pixels 136 that the display pixel 136 would otherwise be blended with are not present. Moreover, perceivable color fringing occurs at a display pixel 136 along a straight border 134 since neighboring display pixels 136 that the display pixel 136 would otherwise be blended with are not present.

To facilitate improving perceived image quality, as described above, image pixel image data 70 is processed based on gain values associated with a corresponding pixel position. Additionally, as described above, a design device 94 determines an uncompressed gain map that explicitly associates (e.g., maps) each pixel position to a gain value set. Accordingly, to determine the uncompressed gain map, the design device 94 determines one or more gain values associated with each pixel position and, thus, each sub-pixel position at the pixel positions.

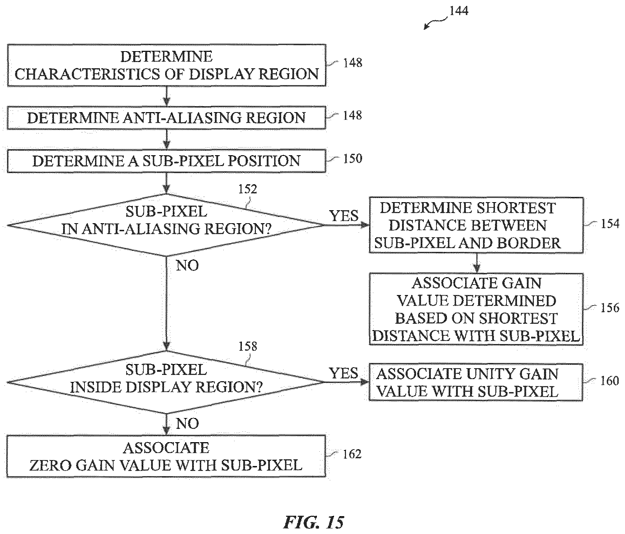

To help illustrate, one embodiment of a process 144 for associating a gain value to a sub-pixel position is described in FIG. 15. Generally, the process 144 includes determining characteristics of a display region (process block 146), determining an anti-aliasing region (process block 148), determining a sub-pixel position (process block 150), and determining whether the sub-pixel position is in the anti-aliasing region (decision block 152). When the sub-pixel position is in the anti-aliasing region, the process 144 includes determining shortest distance between the sub-pixel position and a border of the display region (process block 154) and associating a gain value determined based on the shortest distance with the sub-pixel position (process block 156). When the sub-pixel position is not in the anti-aliasing region, the process 144 includes determining whether the sub-pixel position is within the display region (decision block 158), associating a unity gain value with the sub-pixel positon when the sub-pixel is inside the display region (process block 160), and associating a zero gain value with the sub-pixel positon when the sub-pixel is not inside the display region (process block 162). The process 144 is implemented by executing instructions stored in a tangible non-transitory computer-readable medium, such as the device memory 98, using processing circuitry, such as the device processor 96.

Accordingly, the design device 94 determines expected characteristics of a display region implemented in an electronic display 12 (process block 146). Characteristics of a display region include sub-pixel layout, shape of the display region, location of its border, sub-pixel positions in the display region, and/or the like. Generally, characteristics of an electronic display 12 are fixed. Thus, expected characteristics of the display region are determined and input to the design device 94, by a manufacturer via one or more input devices. Additionally or alternatively, the design device 94 determines expected characteristics of the display region by analyzing the electronic display 12.

To reduce likelihood of producing perceivable aliasing, the design device 94 determines one or more anti-aliasing region along a border of the display region (process block 148). As described above, perceivable aliasing occurs along a rounded border of a display region. Thus, the design device 94 determines an anti-aliasing region along a rounded border of the display region, which includes sub-pixel positions at one or more pixel positions adjacent the rounded border.

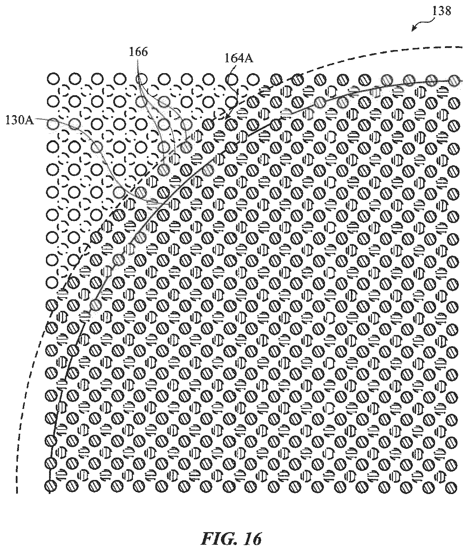

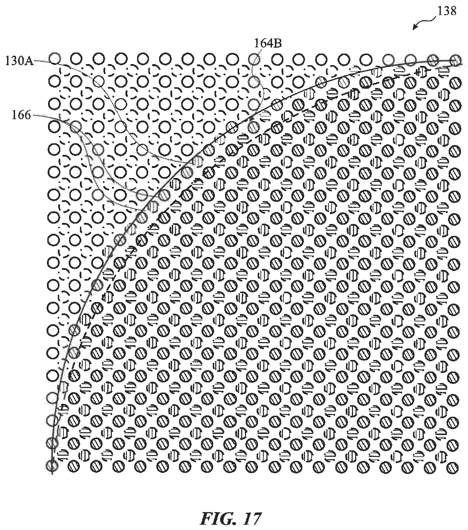

To help illustrate, two examples of anti-aliasing regions 164 along the top-left rounded corner 130A of the non-rectangular display region 128 are shown in FIGS. 16 and 17. In particular, a first anti-aliasing region 164A, which includes sub-pixels positions 166 outside the non-rectangular display region 128, is shown in FIG. 16. On the other hand, a second anti-aliasing region 164B, which includes sub-pixels positions 166 inside the non-rectangular display region 128, is shown in FIG. 17. It should be appreciated that the example anti-aliasing regions 164 are merely intended to be illustrative and not limiting. In other words, other embodiments implement anti-aliasing regions 164 with varying shape and/or varying number of sub-pixel positions.

With regard to FIG. 16, the first anti-aliasing region 164A includes sub-pixels 166 each within a fixed threshold distance from the top-left rounded corner 130A. The fixed threshold distance is the expected distance between adjacent pixel positions, expected distance between adjacent image pixels 126, or expected distance between co-located sub-pixels in adjacent display pixels 136. Thus, an anti-aliasing region 164 is determined to include sub-pixel positions 166 within a uniform distance from a rounded display region border.

Additionally, with regard to FIG. 17, the second anti-aliasing region 164B includes sub-pixel positions 166 each within a variable distance threshold distance from the top left rounded corner 130A. The distance threshold varies based at least in part on curvature of a rounded display region border. Due to shape of the top left rounded corner 130A and sub-pixel layout, the variable distance threshold is larger at a central portion of the top left rounded corner 130A. Thus, an anti-aliasing region 164 is determined to include sub-pixel positions 166 within a variable distance from a rounded display region border.

An anti-aliasing region 164 is indicated by included sub-pixel positions 166. Thus, to facilitate subsequently identifying the anti-aliasing region 164, the design device predetermines characteristics of the anti-aliasing region 164 and stores its included sub-pixel positions in a memory component, such as device memory 98. In a similar manner, the design device 94 determines an anti-aliasing region 164 along each rounded display region border.

Returning to the process 144 of FIG. 15, the design device 94 determines a sub-pixel position (process block 150). As described above, a display pixel 136 includes one or more sub-pixels. Thus, a pixel position corresponding with the display pixel 136 includes a sub-pixel position corresponding with each of the one or more sub-pixels. The sub-pixel position is determined and input to the design device 94, by a manufacturer via one or more input devices. Additionally or alternatively, the design device 94 determines the sub-pixel position by analyzing the electronic display 12 and/or expected image pixel image data 70.

The design device 94 determines whether the sub-pixel position is expected to be within an anti-aliasing region 164 (decision block 152). As described above, an anti-aliasing region 164 is indicated by included sub-pixel position, which is stored in a memory component, such as device memory 98. Thus, the design device 94 polls the memory component to determine sub-pixel positions included in the anti-aliasing region 164 and determines whether the sub-pixel position is expected to be within the anti-aliasing region 164 by comparing the sub-pixel position with the sub-pixel positions included in the anti-aliasing region 164. Additionally or alternatively, the design device 94 determines whether the sub-pixel position is expected to be within the anti-aliasing region 164 based at least in part on a distance threshold associated with the anti-aliasing region 164.

When not within the anti-aliasing region 164, the design device 94 determines whether the sub-pixel position is expected to be inside the display region (decision block 158). As described above, a display region is indicated by included sub-pixel positions, which are stored in a memory component, such as device memory 98. Thus, the design device 94 polls the memory component to determine sub-pixel position included in the display region and determines whether the sub-pixel position is expected to be within the display region by comparing the sub-pixel position with the sub-pixel positions included in the display region.

When the sub-pixel position is not expected to be inside the display region, the design device 94 determines that a sub-pixel is not expected to be implemented in the electronic display 12 at the sub-pixel position and, thus, associates the sub-pixel position with a zero gain value (process block 162). On the other hand, when the sub-pixel position is expected to be inside the display region, the design device 94 determines that a sub-pixel is expected to be implemented in the electronic display 12 at the sub-pixel position and, thus, associates the sub-pixel position with a unity gain value (process block 160). In this manner, the design device 94 determines gain values, which when applied results in a black mask being applied to image data corresponding to sub-pixel positions outside the display region.

When the sub-pixel position is expected to be in the anti-aliasing region 164, the design device 94 determines expected distance between the sub-pixel position and a border of the display region (process block 154). As described above, expected characteristics of the display region are predetermined and stored in a memory component, such as device memory 98. Thus, the design device 94 polls the memory component to determine expected location of the display region border and determines expected distance between the sub-pixel position and the display region border based at least in part on relative distance between the sub-pixel position and the expected location of the display region border.

Based at least in part on shortest distance from the display region border, the design device 94 associates a gain value with the sub-pixel position (process block 156). The gain value is inversely proportional to the shortest distance between the sub-pixel and the display region border. In other words, gain value decreases as expected distance between the sub-pixel and the display region border increases. Applying gain values determined in this manner relatively linearly dims sub-pixels, which reduces likelihood of producing perceivable aliasing along a rounded portion of the display region border.

In a similar manner, the design device 94 associates a gain value with each sub-pixel position and, thus, each pixel position. As described above, an uncompressed gain explicitly associates (e.g., maps) a gain value set to each pixel position. Accordingly, the design device 94 determines an uncompressed gain map based on the gain value associated with each sub-pixel position.

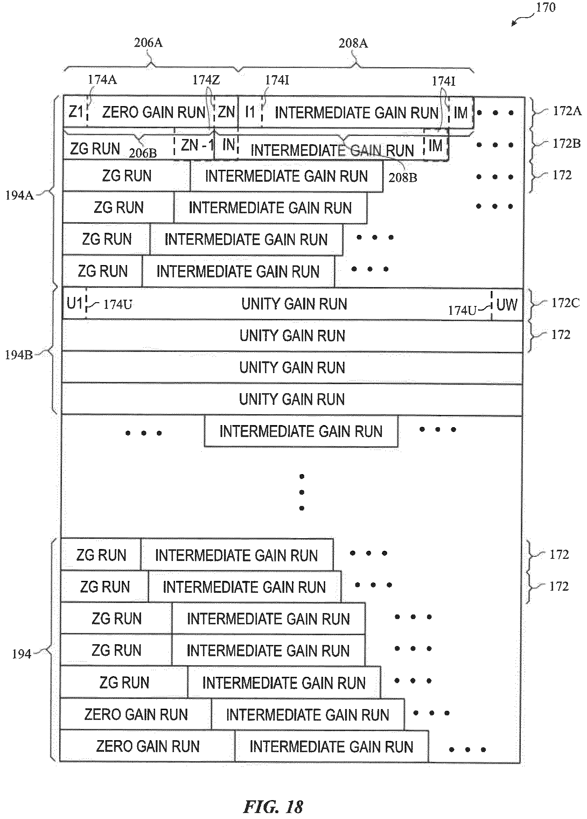

To help illustrate, an example of an uncompressed gain map 170 is shown in FIG. 18. It should be appreciated that the described uncompressed gain map 170 is merely intended to be illustrative and not limiting. In other words, other embodiments implement an uncompressed gain map 170 in other forms.

In any case, in the depicted embodiment, the uncompressed gain map 170 includes gain map entries 174 organized in multiple gain map rows 172. Each gain map entry 174 corresponds with a pixel position and, thus, explicitly maps the pixel position to a gain value set. A first gain map entry 174A associates the pixel position 143 of the first image pixel 126A with a gain value set. As described above, a pixel position includes one or more sub-pixel positions and a gain value set includes a gain value corresponding with each sub-pixel position at the pixel position. In other words, a gain map entry 174 explicitly maps a gain value to each sub-pixel position at a corresponding pixel position.

As described above, size of an uncompressed gain map 170 is dependent on resolution of the electronic display 12 and, thus, is relatively large. Accordingly, the design device 94 stores the uncompressed gain 170 in external memory 44, thereby providing the display pipeline 36 access to the uncompressed gain 170 via a direct memory access channel 58. However, as described above, providing the display pipeline 36 access to the uncompressed gain 170 via a direct memory access channel 58 affects implementation associated cost (e.g., to increase bandwidth of the direct memory access channel 58) and/or processing efficiency of the display pipeline 36.

Thus, returning to the process 112 of FIG. 10, the design device 94 determines a compressed gain map 90 (process block 116). A compressed gain map 90 indirectly associates each pixel position to a gain value set. The display pipeline 36 determines a gain value set associated with a pixel position by decompressing the compressed gain map 90 to determine a corresponding uncompressed gain map 170. Thus, the design device 94 determines the compressed gain map 90 based at least in part on the corresponding uncompressed gain map 170.

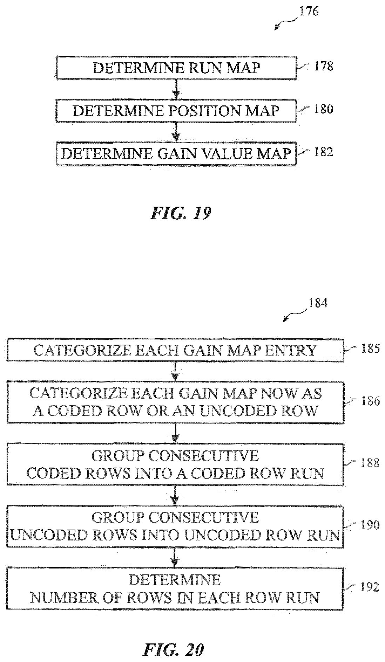

To help illustrate, one embodiment of a process 176 for determining a compressed gain map 90 is described in FIG. 19. Generally, the process 176 includes determining a run map (process block 178), determining a position map (process block 180), and determining a gain value map (process block 182). The process 176 is implemented by executing instructions stored in a tangible non-transitory computer-readable medium, such as the device memory 98, using processing circuitry, such as the device processor 96.

Accordingly, the design device 94 determines the run map 100 based on the uncompressed gain map 170 (process block 178). As described above, the run map 100 indicates number of gain map rows
172 included in each row run. Additionally, as described above, one or more consecutive gain map rows 172 with the same categorization (e.g., coded row or uncoded row) are grouped into a row run (e.g., coded row run or uncoded row run).

One embodiment of a process 184 for determining a run map 100 is described in FIG. 20. Generally, the process 184 includes categorizing each gain map entry (process block 185), categorizing each gain map row as a coded row or an uncoded row (process block 186), grouping consecutive coded rows into a coded row run (process block 188), grouping consecutive uncoded rows into an uncoded run (process block 190), and determining number of gain map rows in each row run (process block 192). The process 184 is implemented by executing instructions stored in a tangible non-transitory computer-readable medium, such as the device memory 98, using processing circuitry, such as the device processor 96.

Accordingly, the design device 94 analyzes the uncompressed gain map 170 to categorize each gain map entry 174 as a zero gain map entry, an intermediate gain map entry, or a unity gain map entry (process block 185). A gain map entry 174 is categorized as a unity gain map entry when each of its gain values is unity. Additionally, a gain map entry 174 is categorized as a zero gain map entry when each of its gain values is zero. Furthermore, a gain map entry 174 is categorized as an intermediate gain map entry when at least one of its gain values is an intermediate gain value (e.g., greater than zero and less than unity).

With regard to the uncompressed gain map 170 of FIG. 18, the design device 94 categorizes each of the first N gain map entries 174 in a first gain map row 172A as a zero gain map entry 174Z and each of the next M gain map entries in the first gain map row 172A as an intermediate gain map entry 174I. Additionally, the design device 94 categorizes each of the first N-1 gain map entries 174 in a second gain map row 172B as a zero gain map entry 174Z and each of the next M gain map entries in the second gain map row 172B as an intermediate gain map entry 174I. Furthermore, the design device 94 categorizes each gain map entry 174 in a seventh gain map row 172C as a unity gain map entry 174U. In this manner, the design device 94 categorizes each gain map entry 174 in an uncompressed gain map 170 as a zero gain map entry 174Z, an intermediate gain map entry 174I, or a unity gain map entry 174U.

Returning to the process 184 of FIG. 20, based at least in part on categorization of the gain map entries 174, the design device 94 categorizes each gain map rows 172 as either a coded row or an uncoded row (process block 186). As described above, a gain map row 172 is categorized as a coded row when at least one of its gain map entries 174 includes an intermediate gain value or a zero gain value. In other words, the design device 94 categorizes a gain map row 172 as a coded row when the gain map row 172 includes at least one zero gain map entry 174Z or intermediate gain map entry 174. With regard to the uncompressed gain map 170 of FIG. 18, the design device 94 categorizes each of the first six gain map rows 172 a coded row since each includes multiple zero gain map entries 174Z and intermediate gain map entries 174.

Additionally, as described above, a gain map row 172 is categorized as an uncoded row when the gain map row 172 only includes unity gain values. In other words, the design device 94 categorizes a gain map row 172 as an uncoded row when the gain map row 172 includes only unity gain map entries 174U. With regard to the uncompressed gain map 170 of FIG. 18, the design device 94 categorizes each of the next four gain map rows 172 an uncoded row since each includes only unity gain map entries 174U. In this manner, the design device 94 categorizes each gain map row 172 in an uncompressed gain map 170 as either a coded row or an uncoded row.

Returning to the process 184 of FIG. 20, the design device 94 groups each gain map row 172 into a row run based at least in part on its row categorization. In particular, the design device 94 groups one or more consecutive gain map row 172, each categorized as a coded row, into a coded row run (process block 188). Additionally, the design device 94 groups one or more consecutive gain map row 172, each categorized as an uncoded row, into an uncoded row run (process block 190). With regard to the uncompressed gain map 170 of FIG. 18, the design device 94 groups the first six gain map rows 172 into a first row run 194A (e.g., coded row run) since each is categorized as a coded row. Additionally, the design device 94 groups the next four gain map rows 172 into a second row run 194B (e.g., uncoded row run) since each is categorized as an uncoded row. In this manner, the design device 94 groups each gain map row 172 of an uncompressed gain map 170 in a row run.

Returning to the process 184 of FIG. 20, the design device 94 determines number of gain map rows 172 in each row run (process block 192). With regard to the uncompressed gain map 170 of FIG. 18, the design device 94 determines that the first row run 194A includes six gain map rows 172 and, thus, indicates a value of six in a first run map entry. Additionally, the design device 94 determines that second row run 194B includes four gain map rows 172 and, thus, indicates a value of four in a second run map entry. In this manner, the design device 94 determines the run map 100 such that each run map entries indicates number of gain map row 172 of an uncompressed gain map 170 included in a corresponding row run.

To facilitate subsequent decompression, the run map 100 explicitly indicates whether each row run 194 is a coded row run or an uncoded row run. To facilitate further reducing size of the compressed gain map 90, the design device 94 determines a starting row run indicator 108 and alternates between categorizing consecutive row runs 194 as coded row runs and uncoded row runs. Categorization of the first row run 194A is determined based on the starting row run indicator 108 and categorization of each subsequent row run 194 is determined based on categorization of a directly previous (e.g., top neighbor) row run 194, thereby obviating bits that would otherwise be used to explicitly specify whether each of the subsequent row runs 194 is a coded row run or an uncoded row run. In this manner, the design device 94 determines the run map 100 and one or more starting row run indicators 108 to facilitate determining categorization of each row run 194 and, thus, categorization of each gain map row 172 and/or gain values associated with pixel positions in uncoded rows by the display pipeline 36.

Returning to the process 176 of FIG. 19, the design device 94 determines the position map 102 based at least in part on the uncompressed gain map 170 (process block 180). As described above, the position map 102 indicates number of gain map entries 174 included in each gain run of a coded row. Additionally, as described above, one or more consecutive gain map entries with the same categorization are grouped into a gain run.

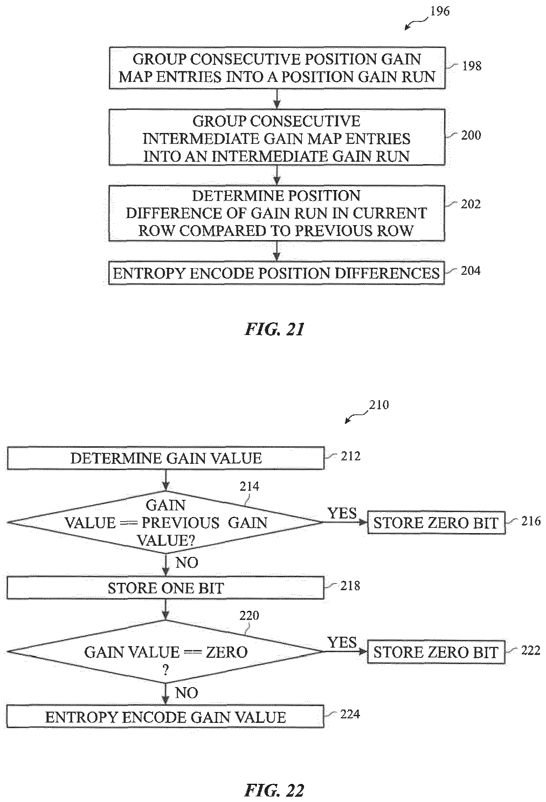

One embodiment of a process 196 for determining a position map 102 is described in FIG. 21. Generally, the process 196 includes grouping consecutive position gain map entries into a position gain run (process block 198), grouping consecutive intermediate gain map entries into an intermediate gain run (process block 200), determining position difference between a gain run in a current row compared to a previous row (process block 202), and entropy encoding the position differences (process block 204). The process 196 is implemented by executing instructions stored in a tangible non-transitory computer-readable medium, such as the device memory 98, using processing circuitry, such as the device processor 96.

Accordingly, the design device 94 groups consecutive gain map entries 174 in a coded row into gain runs based at least in part on respective entry categorization. In particular, the design device 94 groups one or more consecutive zero gain map entries 174Z or one or more consecutive unity gain map entries 174U into a position gain run (process block 198). In other words, a position gain run is a zero gain run, which includes only zero gain map entries 174Z, or a unity gain run, which includes only unity gain map entries 174U. Additionally, the design device 94 groups one or more consecutive intermediate gain map entries 174I into an intermediate gain run (process block 200).

With regard to the uncompressed gain map 170 of FIG. 18, the design device 94 groups the first N gain map entries 174 in the first gain map row 172A into a first position gain run 206A since each is a categorized as a zero gain map entry 174Z. Additionally, the design device 94 groups the next M gain map entries 174 in the first gain map row 172A into a first intermediate gain run 208A since each is a categorized as an intermediate gain map entry 174I. Furthermore, the design device 94 groups the first N-1 gain map entries 174 in a second gain map row 172 into a second position gain run 206B and the next M gain entries into a second intermediate gain run 208B.

Based at least in part on number of gain map entries 174 in each preceding gain run, gain map entries 174 and, thus, pixel positions included in each gain run are determined. Indicating that the first position gain run 206A includes the N gain map entries 174 enables determining that the first N gain map entries 174 of the first gain map row 172A are included in the first and that the first intermediate gain run 208A starts at the N+1th gain map entry 174 of the first gain map row 172A. Additionally, indicating that the first intermediate gain run 208A includes M gain map entries 174 enables determining that the next M gain map entries 174 of the first gain map row 172A are included in the first intermediate gain run 208A and that the first intermediate gain run 208A ends on the N+Mth gain map entry 174 of the first gain map row 172A. Thus, to facilitate subsequent decompression, the position map 102 explicitly indicates number of gain map entries 174 included in each gain run.

Returning to the process 196 of FIG. 21, the design device 94 determines position difference of a gain run in a current row compared to a directly previous (e.g., top neighbor) row (process block 202) and entropy encodes the position difference (process block 204) to facilitate further reducing size of the compressed gain map 90. The position difference indicates number of pixel positions separating a starting gain map entry 174 of a gain run in the current row and a starting gain map entry 174 of a corresponding gain run in the directly previous row.

With regard to the uncompressed gain map 170 of FIG. 18, the design device 94 determines that the first intermediate gain run 208A starts at the N+1th gain map entry 174 of the first gain map row 172A. Additionally, the design device 94 determines that the second intermediate gain run 208B starts at the Nth gain map entry 174 of the second gain map row 172B. Thus, instead of explicitly indicating that the second position gain run of the second gain map row 172B includes N-1 gain map entries 174, the starting gain map entry 174 of the second intermediate gain run 208 is indicated as one pixel position before the starting gain map entry 174 of the first intermediate gain run 208 in the first gain map row 172A. Additionally, the position difference is entropy encoded using an exponential-Golomb encoding algorithm. In this manner, the design device 94 determines the position map 102 to facilitate determining pixel positions in each gain run of a coded row.

In any case, to facilitate subsequent decompression, the compressed gain map 90 indicates whether the position gain run is a zero gain run or a unity gain run. As described above, a position gain value indicator 110 indicates a gain value of each gain map entry 174 in a corresponding position gain run. Thus, the design device 94 determines and associates a position gain value indicator 110 with each position gain run.

With regard to the uncompressed gain map 170 of FIG. 18, the design device 94 associates a first position gain value indicator 110 with the first position gain run 206A, which indicates that each gain map entry 174 in the first position gain run is a zero gain map entry 174Z. Additionally, the design device 94 associates a second position gain value indicator 110 with the second position gain run 206B, which indicates that each gain map entry 174 in the second position gain run is a zero gain map entry 174Z. Additionally or alternatively, the design device 94 associates a position gain value indicator 110 with a position gain run, which indicates that each gain map entry 174 in the position gain run is a unity gain map entry 174U. In this manner, the design device 94 determines the position map 102 and one or more position gain value indicators 110 to facilitate determining gain values associated with each pixel position in a position gain run by the display pipeline 36.

Returning to the process 176 of FIG. 17, the design device 94 determines the gain value map 104 based at least in part on the uncompressed gain map 170 (process block 182). As described above, the gain value map 104 indicates gain values of gain map entries 174 and, thus, gain values associated with corresponding pixel position in each intermediate gain run. Additionally, the gain value map 104 indicates gain values of a gain map entry 174 based at least in part on gain values of a directly previous (e.g., left neighbor) gain map entry 174.

One embodiment of a process 210 for determining a gain value map 104 is described in FIG. 22. Generally, the process 210 includes determining a gain value (process block 212), determining whether the gain value is equal to a previous gain value (decision block 214), and storing a zero bit when the gain value is equal to the previous gain value (process block 216). Additionally, when the gain value does not equal the previous gain value, the process 210 includes storing a one bit (process block 218), determining whether the gain value is equal to zero (decision block 220), storing a zero bit when the gain value is equal to zero (process block 222), and entropy encoding the gain value when the gain value is not equal to zero (process block 224). The process 210 is implemented by executing instructions stored in a tangible non-transitory computer-readable medium, such as the device memory 98, using processing circuitry, such as the device processor 96.

Accordingly, the design device 94 determines a gain value associated with a current gain map entry 174 in an intermediate gain run from the uncompressed gain map 170 (process block 212). Additionally, the design device 94 determines a gain value associated with a directly previous gain map entry 174 from the uncompressed gain map 170. Image data corresponding with a display pixel row is processed from left to right. Thus, the directly previous gain map entry 174 is the left neighbor of the current gain map entry 174.

As described above, a gain map entry 174 includes multiple gain values each associated with a different color component and/or a different sub-pixel. Generally, factors affecting gain values to be applied at adjacent display pixels 136 are relatively similar. As such, gain values corresponding to the same color component at adjacent pixel positions are relatively similar or even the same. Thus, the design device 94 compares the gain value included in the current gain map entry 174 with a gain value associated with the same color component in the directly previous gain map entry 174 to determine whether they are equal (decision block 214).

When the gain values are equal, the design device 94 stores a zero bit in the gain value map 104 (process block 216). On the other hand, when the gain values are not equal, the design device 94 stores a one bit in the gain value map 104 (process block 218). Thus, when the compressed gain map 90 is subsequently decompressed, the first bit associated with the current gain map entry 174 indicates whether a gain value in the current gain map entry 174 is the same as a corresponding gain value in the directly previous gain map entry 174. Moreover, when the gain values are equal, compressing in this manner obviates bits that would otherwise be used to explicitly indicate one or more of the gain values, thereby enabling size of the compressed gain map 90 to be reduced.

When the gain values are not equal, the design device 94 determines whether the gain value in the current gain map entry 174 is equal to zero (decision block 220). Additionally, when the gain value in the current gain map entry 174 is equal to zero, the design device 94 stores a zero bit in the gain value map 104 (process block 222). Thus, when the gain value of the current gain map entry 174 is equal to zero, compressing in this manner obviates bits that would otherwise be used to explicitly indicate the gain value, thereby enabling size of the compressed gain map 90 to be reduced.

On the other hand, when the gain value is not equal to zero, the design device 94 entropy encodes the gain value of the current gain map entry 174 (process block 224). The design device 94 entropy encodes the gain value using an exponential-Golomb encoding algorithm. In this manner, the design device 94 determines the gain value map 104 such that gain value map entries indicate gain values associated with pixel positions in each intermediate gain run.

Utilizing the compression techniques described above, the design device 94 determines the compressed gain map 90, which includes the run map 100, the position map 102, the gain value map 104, and one or more programmable indicators (e.g., a starting row run indicator 108 and/or a position gain value indicator 110). It should be appreciated that the compression techniques are applicable any uncompressed gain map 170, even when not implemented to apply gain values along a display region border. Compression efficiency of the described compression techniques improves as number of uncoded rows increases, number of pixel positions in position gain runs increases, number of consecutive pixel positions associated with the same gain value increases, and/or number of pixel positions in intermediate gain runs decreases. Thus, the compression techniques are useful for compressing a gain map to be applied to relatively uniform content.

Returning to the process 112 of FIG. 10, the design device 94 stores the compressed gain map 90 in a memory component to enable subsequent access from the memory component (process block 118). As described above, size of a compressed gain map 90 is smaller than size of a corresponding uncompressed gain map 170. This reduction in size enables storing the compressed gain map 90 in the internal memory 46 of the display pipeline 36, which, as described above, facilitates improving processing efficiency and/or reducing implementation associated cost. The compressed gain map 90 is nevertheless stored in the external memory 44. In any case, as described above, the sub-pixel layout resampler block 56 subsequently accesses the gain map and processes image data based at least in part on gain values indicated by the gain map.

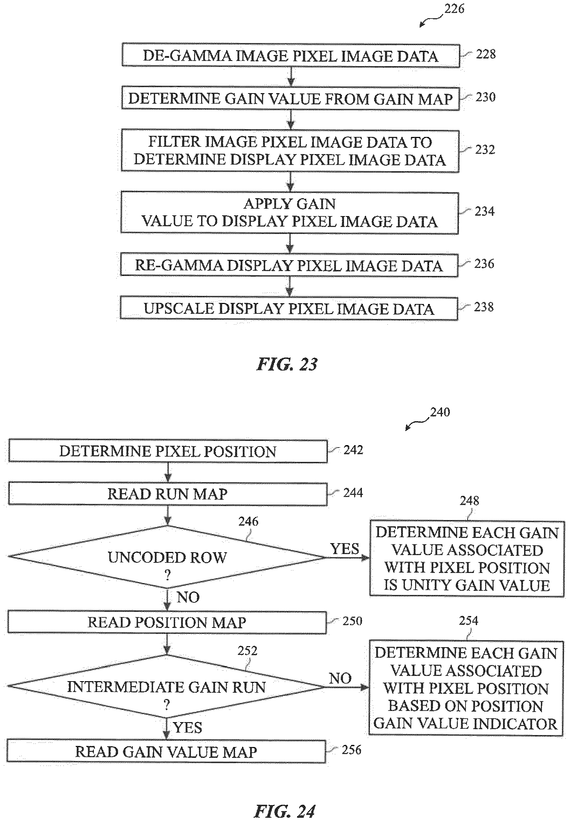

To help illustrate, one embodiment of a process 226 for operating a sub-pixel layout resampler block 56 is described in FIG. 23. Generally, the process 226 includes de-gamma converting image pixel image data (process block 228), determining a gain value from a gain map (process block 230), filtering the image pixel image data to determine display pixel image data (process block 232), applying the gain value to the display pixel image data (process block 234), re-gamma converting the display pixel image data (process block 236), and upscaling the display pixel image data (process block 238). The process 226 is implemented based on circuit connections formed in the display pipeline 36. Additionally or alternatively, the process 226 is implemented by executing instructions stored in a tangible, non-transitory, computer-readable medium, such as the controller memory 52, using processing circuitry, such as the controller processor 50.

Accordingly, the sub-pixel layout resampler block 56 de-gamma converts image pixel image data 70 (process block 228). As described above, the sub-pixel layout resampler block 56 receives image pixel image data 70 in a gamma (e.g. non-linear) domain. To facilitate subsequent processing, the sub-pixel layout resampler block 56 de-gammas by converting the image pixel image data 70 from a gamma domain to a linear domain.

Additionally, the sub-pixel layout resampler block 56 determines one or more gain value from a gain map (process block 230). As described above, an uncompressed gain map 170 is stored in the external memory 44. Thus, the sub-pixel layout resampler block 56 retrieves at least a portion (e.g., gain map entry 174) of the uncompressed gain map 170, which explicitly indicates one or more gain values associated with a corresponding pixel position, from the external memory 44 via a direct memory access channel 58.

As described above, a compressed gain map 90 is stored in the internal memory 46. Thus, the sub-pixel layout resampler block 56 retrieves at least a portion of the compressed gain map 90 from the internal memory 46. Since compressed, the sub-pixel layout resampler block 56 decompresses the compressed gain map 90 to determine one or more gain values associated with a corresponding pixel position.

One embodiment of a process 240 for decompressing a compressed gain map 90 is described in FIG. 24. Generally, the process 240 includes determining a pixel position (process block 242), reading a run map (process block 244), determining whether the pixel position is in an uncoded row (decision block 246), and determining that each gain value associated with the pixel position is a unity gain value when the pixel position is in an uncoded row (process block 248). When the pixel position is not in an uncoded row, the process 240 includes reading a position map (process block 250), determining whether the pixel position is in an intermediate gain run (decision block 252), determining each gain value associated with the pixel position based on a position gain value indicator when the pixel position is not in an intermediate gain run (process block 254), and reading a gain value map when the pixel position is in an intermediate gain run (process block 256). The process 240 is implemented based on circuit connections formed in the display pipeline 36. Additionally or alternatively, the process 240 is implemented by executing instructions stored in a tangible, non-transitory, computer-readable medium, such as the controller memory 52, using processing circuitry, such as the controller processor 50.

Accordingly, the sub-pixel layout resampler block 56 determines a pixel position corresponding with received image pixel image data 70 (process block 242). The sub-pixel layout resampler block 56 receives image pixel image data 70 as a bit stream. Thus, the sub-pixel layout resampler block 56 determines the pixel position based at least in part on order with which the image pixel image data 70 is received and/or resolution of the electronic display 12. Based on the pixel position, the sub-pixel layout resampler block 56 determines a corresponding gain map entry 174 and, thus, a gain map row 172 that includes a gain map entry 174.

Additionally, the sub-pixel layout resampler block 56 reads the run map 100 to determine row categorization of the gain map row 172 (process block 244). As described above, the run map 100 indicates number of gain map rows 172 included in each row run 194. Thus, based at least in part the run map 100, the sub-pixel layout resampler block 56 identifies a row run 194 that includes the gain map row 172 and, thus, the pixel position. Run map 100 is stored in the internal memory 46 of the display pipeline 36. Thus, the sub-pixel layout resampler block 56 reads the run map 100 from the internal memory 46.

To facilitate determining categorization of the row run, the sub-pixel layout resampler block 56 reads a starting row run indicator 108. As described above, a starting row run indicator 108 indicates whether a corresponding row run 194 is a coded row run or an uncoded row run. To facilitate reducing size of the compressed gain map 90, a starting row run indicator 108 is only specified for a first row run 194A. When the row run 194 is not the first row run 194A, the sub-pixel layout resampler block 56 determines categorization of the row run 194 based at least in part on categorization of a directly previous (e.g., top neighbor) row run 194. In other words, the sub-pixel layout resampler block 56 determines categorization of the row run 194 based on number of other row runs 194 separating the row run 194 from the first row run 194A.

Accordingly, based at least in part the run map 100 and the starting row run indicator 108, the sub-pixel layout resampler block 56 determines whether the row run 194 is an uncoded row run and, thus, whether the gain map row 172 including the pixel position is an uncoded row (decision block 246). As described above, a gain map row 172 is an uncoded row when each of the gain values are equal to unity. Thus, when the display pipeline determines that a pixel position is in an uncoded row, the sub-pixel layout resampler block 56 determines that each gain value to be used to process the image pixel image data 70 is a unity gain value (process block 248).

On the other hand, not an uncoded row, the sub-pixel layout resampler block 56 determines that the gain map row 172 is a coded row and, thus, reads the position map 102 (process block 250). As described above, a position map 102 indicates pixel positions included in each gain run of a coded row. Position map 102 is stored in the internal memory 46 of the display pipeline 36. Thus, the sub-pixel layout resampler block 56 reads the position map 102 from the internal memory 46.

Additionally, a position map 102 is entropy encoded. Thus, the sub-pixel layout resampler block 56 determines pixel positions included in each gain run by entropy decoding the position map 102. The sub-pixel layout resampler block 56 entropy decodes the position map 102 using an exponential-Golomb decoding algorithm. Furthermore, a position map 102 indicates the pixel positions included in a gain run relative to another gain run based on a position difference. Thus, the sub-pixel layout resampler block 56 determines the pixel positions included in the gain run by applying the position difference to a (e.g., starting or ending) pixel position in the other gain run.

Based at least in part on the position map 102, the sub-pixel layout resampler block 56 determines whether the pixel position is in an intermediate gain run (decision block 252). As described above, each gain map entry 174 in an intermediate gain run includes one or more intermediate gain values (e.g., greater than zero and less than unity). Accordingly, when not in an intermediate gain run, the sub-pixel layout resampler block 56 determines that the pixel position is in a position run and, thus, determines the gain values to be used to process the image pixel image data 70 based on a corresponding position gain value indicator 110. A position gain value indicator 110 is stored in a programmable register 106. Thus, the sub-pixel layout resampler block 56 determines the position gain value indicator 110 by polling the programmable register 106.

On the other hand, when in an intermediate gain run, the sub-pixel layout resampler block 56 reads the gain value map 104 (process block 256). As described above, a gain value map 104 indicates gain values in an intermediate gain run. The gain value map 104 is stored in the internal memory 46 of the display pipeline 36. Thus, the sub-pixel layout resampler block 56 reads the gain value map 104 from the internal memory 46.

Additionally, a gain value map 104 is entropy encoded. Thus, the sub-pixel layout resampler block 56 determines the gain values associated with the pixel position by entropy decoding the gain value map 104. The sub-pixel layout resampler block 56 entropy decodes the gain value map 104 using an exponential-Golomb decoding algorithm. In this manner, the sub-pixel layout resampler block 56 decompresses the compressed gain map 90 to determine one or more gain value associated with a pixel position corresponding with the image pixel image data 70.

Returning to the process 226 of FIG. 23, the sub-pixel layout resampler block 56 filters the image pixel image data 70 to determine corresponding display pixel image data 72 (process block 232). As described above, the sub-pixel layout resampler block 56 filters the image pixel image data 70 based on filter parameters, such as offset filter phase values and/or offset sub-pixel filter coefficients. Additionally, the sub-pixel layout resampler block 56 determines the filter parameters to be applied based at least in part on the gain values determined from the gain map.

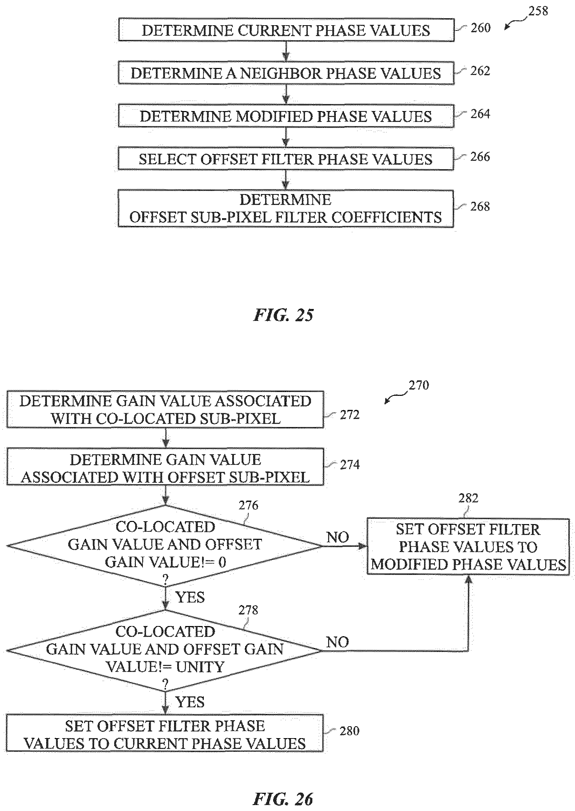

To help illustrate, one embodiment of a process 258 for determining filter phase values and offset sub-pixel filter coefficients is described in FIG. 25. Generally, the process 258 includes determining current phase values (process block 260), determining neighbor phase values (process block 262), determining modified phase values (process block 264), selecting offset filter phase values (process block 266), and determining offset sub-pixel filter coefficients (process block 268). The process 258 is implemented based on circuit connections formed in the display pipeline 36. Additionally or alternatively, the process 258 is implemented by executing instructions stored in a tangible non-transitory computer-readable medium, such as the controller memory 52, using processing circuitry, such as the controller processor 50.

Accordingly, the sub-pixel layout resampler block 56 determines phase values associated with a current image pixel block, which includes a current image pixel corresponding with the received image pixel image data 70 (process block 260). The current image pixel block is a 2x2 block of image pixels surrounding an offset sub-pixel of a current display pixel 136 corresponding with the current image pixel. Additionally, the sub-pixel layout resampler block 56 determines a current phase value based at least in part on difference metrics associated with the current image pixel block, such as sum of absolute difference between the current image pixel block and a neighbor image pixel block offset from the current image pixel block. A current phase value indicates variation of the filtering to be applied compared to a default filter (e.g., equal interpolation) mode.

Additionally, the sub-pixel layout resampler block 56 determines phase values associated with each neighbor image pixel block (process block 262). The sub-pixel layout resampler block 56 determines the neighbor phase values associated with a neighbor block in a similar manner as the current phase values associated with the current block. The sub-pixel layout resampler block 56 determines a top neighbor phase value corresponding with the top neighbor block based at least in part on difference metrics associated with the top neighbor image pixel block.

Based at least in part on the current phase values and the neighbor phase values, the sub-pixel layout resampler block 56 determines modified phase values (process block 264). The sub-pixel layout resampler block 56 determines the modified phase values by filtering the current phase values based on the neighbor phase values. The sub-pixel layout resampler block 56 determines a modified filter phase values by filtering the current filter phase values with a neighbor filter phase value of each neighbor image pixel block.

Additionally, the sub-pixel layout resampler block 56 determines offset filter phase values (process block 266). The sub-pixel layout resampler block 56 sets the offset filter phase values based at least in part on the current phase values and/or the modified phase values. The sub-pixel layout resampler block 56 sets the offset filter phase values as the current phase values or as the modified phase values based at least in part on gain values (e.g., offset gain value and/or co-located gain value) associated with the pixel position of the current image pixel in a gain map.

To help illustrate, one embodiment of a process 270 for determining the offset filter phase values is shown in FIG. 26. Generally, the process 270 includes determining gain value associated with a co-located sub-pixel (process block 272), determining gain value associated with an offset sub-pixel (process block 274), determining whether the co-located gain and the offset gain both are not zero (decision block 276), and determining whether the co-located gain and the offset gain are both not unity (decision block 278). When the co-located gain is not zero or unity and the offset gain is not zero or unity, the process 270 includes setting offset filter phase values to current phase values (process block 280). Otherwise, the process 270 includes setting the offset filter phase values to modified phase values (process block 282). The process 270 is implemented based on circuit connections formed in the display pipeline 36. Additionally or alternatively, the process 270 is implemented by executing instructions stored in a tangible non-transitory computer-readable medium, such as the controller memory 52, using processing circuitry, such as the controller processor 50.

Accordingly, the sub-pixel layout resampler block 56 determines a gain value to be applied at the co-located sub-pixel in the current display pixel (process block 272). Additionally, the controller 42 instructs the sub-pixel layout resampler block 56 to determine a gain value to be applied at the offset sub-pixel in the current display pixel (process block 274). The sub-pixel layout resampler block 56 determines the gain value associated with the co-located sub-pixel and/or the gain value associated with the offset sub-pixel based at least in part on a compressed gain map 90, by decompressing the compressed gain map 90 using the process 240 of FIG. 24.

Based at least in part on the gain values, the sub-pixel layout resampler block 56 sets the offset filter phase values as the modified phase values (process block 282) or sets the offset filter phase values as the current phase values (process block 280). The sub-pixel layout resampler block 56 sets an offset filter phase to the current filter phase when the co-located gain and offset gain both do not equal zero or unity. On the other hand, the sub-pixel layout resampler block 56 sets the offset filter phase to the modified filter phase when at least one of the co-located gain and the offset gain is equal to zero or unity. In this manner, the sub-pixel layout resampler block 56 determines the offset filter phase values based at least in part on the gain values associated with a current pixel position.

Returning to the process 258 of FIG. 25, the sub-pixel layout resampler block 56 determines offset sub-pixel filter coefficients based at least in part on the offset filter phase values (process block 268). The offset sub-pixel filter coefficients are used to implement the offset filter phase values. Thus, the sub-pixel layout resampler block 56 determines the offset sub-pixel filter coefficients to be applied to by the filter block 82. In this manner, the sub-pixel layout resampler block 56 determines filter parameters (e.g., offset filter phase values and/or offset sub-pixel filter coefficients) to be applied to the image pixel image data 70 based at least in part on the gain values associated with a current pixel position in a gain map.

Returning to the process 226 of FIG. 23, the sub-pixel layout resampler block 56 determines display pixel image data 72 corresponding with the current pixel position based at least in part on the filter parameters (process block 114). The sub-pixel layout resampler block 56 filters image pixel image data 70 corresponding with a group of image pixels around the current image pixel based on the filter parameters to determine the display pixel image data 72.

After filtering, the sub-pixel layout resampler block 56 applies gain values to the display pixel image data 72 (process block 234). As described above, a gain map indicates gain values associated with each pixel position. Additionally, as described above, programmable border gain value indicators 92 indicate gain values selectively applied at pixel positions along the display region border. Thus, the sub-pixel layout resampler block 56 determines whether to apply gain values indicated by the gain map or gain values indicated by a programmable border gain value indicator 92.

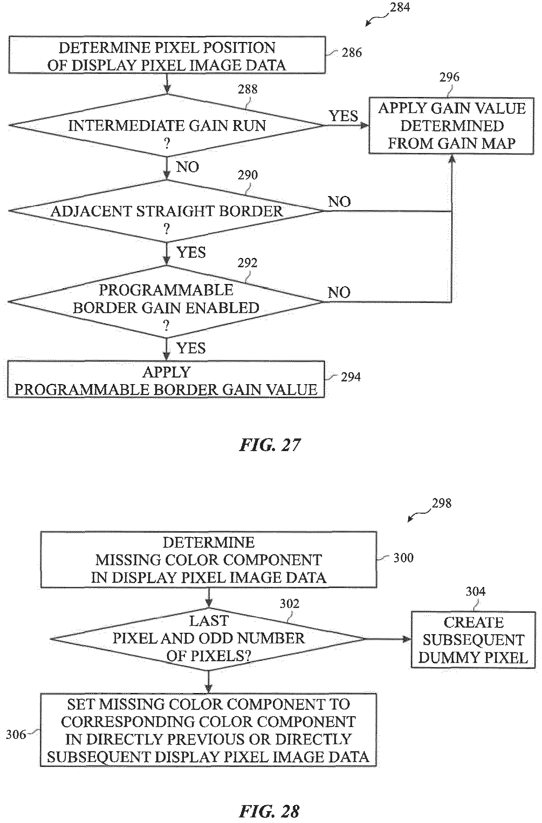

To help illustrate, one embodiment of a process 284 for applying a gain value to display pixel image data 72 is described in FIG. 27. Generally, the process 284 includes determining a pixel position of display pixel image data (process block 286), determining whether the pixel position is in an intermediate gain run (decision block 288), determining whether the pixel position is adjacent a straight border (decision block 290), determining whether programmable border gain is enabled (decision block 292), and applying a programmable border gain value when the pixel position is not in an intermediate gain run, the pixel position is adjacent a straight border, and programmable border gain is enabled (process bock 294). Additionally, the process 284 includes applying a gain value determined from a gain map when the pixel position is in an intermediate gain run, the pixel position is not adjacent a straight border, or the programmable border gain is not enabled (process block 296). The process 284 is implemented based on circuit connections formed in the display pipeline 36. Additionally or alternatively, the process 284 is implemented by executing instructions stored in a tangible non-transitory computer-readable medium, such as the controller memory 52, using processing circuitry, such as the controller processor 50.

Accordingly, the sub-pixel layout resampler block 56 determines a pixel position corresponding with display pixel image data 72 (process block 286). As described above, display pixel image data 72 is determined by processing corresponding image pixel image data 70. In other words, the display pixel image data 72 corresponds to the same pixel position as the image pixel image data 70. As such, the sub-pixel layout resampler block 56 determines the pixel position corresponding with the display pixel image data 72 by determining the pixel position corresponding with the image pixel image data 70, based at least in part on order with which the image pixel image data 70 is received and/or resolution of the electronic display 12.

Additionally, the sub-pixel layout resampler block 56 determines whether the pixel position is in an intermediate gain run (process block 288). As described above, the run map 100 indicates number of gain map rows 172 included in each row run 194 and a starting row run indicator 108 indicates categorization of each row run 194. Accordingly, based at least in part on the run map 100 and the starting row run indicator 108, the sub-pixel layout resampler block 56 determines categorization of a row run 194 including the pixel position and, thus, whether the pixel position is included in a coded row or an uncoded row. Since an uncoded row includes only unity gain values, the sub-pixel layout resampler block 56 determines that the pixel position is not in an intermediate gain run when in an uncoded row.

Additionally, as described above, the position map 102 indicates pixel positions included in each gain run of a coded row and a position gain value indicator 110 is associated with each position gain run. Thus, based at least in part on the position map 102 and the position gain value indicators 110, the sub-pixel layout resampler block 56 determines pixel positions in each intermediate gain run and, thus, whether the pixel position is in an intermediate gain run.

Furthermore, the sub-pixel layout resampler block 56 determines whether the pixel position is adjacent a straight border of a display region (decision block 290). The border detection block 86 determines whether the pixel position is adjacent a straight border based at least in part on characteristics of the display region. The border detection block 86 determines whether the pixel position is adjacent a straight border based at least in part on location of the display region border and/or pixel positions predefined as adjacent a straight border. As described above, expected characteristics of the display region are predetermined and stored in a memory component, such as device memory 98. Thus, the design device 94 polls the memory component to determine the characteristics of the display region.

The sub-pixel layout resampler block 56 also determines whether programmable border gain is enabled (decision block 292). The sub-pixel layout resampler block 56 determines whether programmable border gain is enabled based at least in part on indicator, stored in the internal memory 46 or a programmable register 106. The sub-pixel layout resample block 56 determines that programmable border gain is enabled when the indicator has a first value (e.g., 1 bit) and that programmable border gain is enabled when the indicator has a second value (e.g., 0 bit).

Based on these determinations, the sub-pixel layout resampler block 56 applies either gain values determined from the gain map (process block 296) or a programmable border gain value 92 (process block 294). As described above, applying gain values from the gain map facilitates adjusting an image or image frame for display on a display region with a different (e.g. non-rectangular) shape, by applying a black mask at pixel positions outside the display region. Additionally, as described above, applying gain values from the gain map dims sub-pixels along a rounded border of the display region to facilitate reducing likelihood of producing perceivable aliasing along the rounded border.

Moreover, the programmable border gain value is determined to reduce likelihood of producing perceivable color fringing along a border (e.g., straight border) of the display region. In some instances, fringing occurring along a border is affected by sub-pixel layout implemented in an electronic display 12. In other words, fringing occurring along different borders varies. When display pixels 136 of the electronic display each include a green sub-pixel and alternatingly either a red sub-pixel or a blue sub-pixel, green fringing occurs along a first (e.g., top) straight border while violet fringing occurs along a second (e.g., left) straight border.

Thus, to reduce likelihood of producing perceivable color fringing, different programmable border gain values are associated with different borders. As such, when a programmable border gain value is to be applied, the sub-pixel layout resampler block 56 determines which border is adjacent the pixel position and selects a corresponding programmable border gain value. In this manner, the sub-pixel layout resampler block 56 facilitates improving perceived image quality of an electronic display by selectively (e.g., adaptively) applying gain values to the display pixel image data 72.

Returning to the process 226 of FIG. 23, when output image data is expected to be in the gamma domain, the sub-pixel layout resampler block 56 converts the display pixel image data 72 from the linear domain to the gamma domain (process block 236). Furthermore, when output image data is expected to be in a source format (e.g., RGB format), the sub-pixel layout resampler block 56 upscales the display pixel image data 72 to convert from a display format (e.g., GR or GB format) to the source format (process block 238). The sub-pixel layout resampler block 56 converts to the source format by adding image data corresponding with a missing color component to the display pixel image data 72.

To help illustrate, one embodiment of a process 298 for converting display pixel image data 72 from a display format to a source format is described in FIG. 28. Generally, the process 298 includes determining a missing color component in display pixel image data (process block 300), determining whether a display pixel corresponding with the display pixel image data is a last pixel and an image includes an odd number of image pixels (decision block 302), and creating a subsequent dummy pixel when the display pixel is the last pixel and the image includes an odd number of pixels (process block 304). Additionally, the process 298 includes setting the missing component to a corresponding color component in a directly previous or directly subsequent display pixel image data (process block 306). The process 298 is implemented based on circuit connections formed in the display pipeline 36. Additionally or alternatively, the process 298 is implemented by executing instructions stored in a tangible non-transitory computer-readable medium, such as the controller memory 52, using processing circuitry, such as the controller processor 50.

Accordingly, the sub-pixel layout resampler block 56 determines a missing component from the display pixel image data 72 corresponding with the current display pixel (process block 300). When the display pixel image data 72 is in a GR format, the sub-pixel layout resampler block 56 determines that the blue component is missing. On the other hand, when the display pixel image data 72 is in a GB format, the sub-pixel layout resampler block 56 determines that the red component is missing.

To convert to the source format (e.g., RGB format), the controller 42 instructs the sub-pixel layout resampler block 56 to copy image data of the missing color component from a directly previous or directly subsequent display pixel image data (process block 306). When the blue color component is missing from current display pixel image data, the sub-pixel layout resampler block copies blue component image data from directly previous display pixel image data into the current display pixel image data and copies red component image data from the current display pixel image data to the directly previous display pixel image data.

Thus, when the current display pixel is the last display pixel and the image includes an odd number of image pixels, subsequent display pixel image data is unavailable for swapping color component image data with the current display pixel image data. Thus, the controller 42 instructs the sub-pixel layout resampler block 56 to create a subsequent dummy pixel (process block 304). The dummy pixel includes image data with each color component set to zero. The dummy pixel is a copy of other display pixel image data and/or includes image data with color components set to any suitable value. In this manner, the sub-pixel layout resampler block 56 determines display pixel image data 72, which when used to display an image provides improved perceived image quality.

As described above, a compressed gain map 90 indicates gain values associated with a pixel position 126 in a relative manner and/or relative another pixel position 126. The display pipeline 56 experiences data dependencies when decompressing a compressed gain map 90, thereby limiting decompression efficiency (e.g., rate with which gain values associated with a pixel position are determined).

To facilitate improving decompression efficiency, pixel positions 126 and associated gain values are grouped into multiple pixel regions, by dividing an uncompressed gain map 170 into multiple uncompressed gain maps 170. By compressing each uncompressed gain map 170, multiple compressed gain maps 90 each corresponding to one of the pixel regions are determined. In this manner, data dependencies between gain values associated with pixel positions in different pixel regions are reduced. In fact, implementing multiple compressed gain maps 90 in this manner enables the display pipeline 56 to vary order with which gain values are determined and, thus, access (e.g., fetch) pattern to the compressed gain maps. The display pipeline 56 controls gain value determination order to improve memory access efficiency, by implementing a random access pattern.

## Claims

1. An electronic device, comprising:
an electronic display, wherein the electronic display comprises:
a display region with a rounded border; and
a first display pixel of a plurality of pixels at a first pixel position adjacent the rounded border; and
a display pipeline circuitry comprising one or more image data processing circuits, wherein the one or more image data processing circuits comprise a sub-pixel layout resampler circuitry, wherein the display pipeline circuitry is communicatively coupled to the electronic display, and wherein the sub-pixel layout resampler circuitry is configured to:
receive first image data that indicates target luminance at the first pixel position in an image frame, wherein the image frame has a rectangular shape;
determine a first gain value associated with the first pixel position from a compressed gain map that is based on an uncompressed gain map, wherein the compressed gain map comprises a coded row run of one or more coded rows of the uncompressed gain map and an uncoded row run of one or more uncoded rows of the uncompressed gain map, wherein the coded row run indicates a gain map entry of a gain value for a respective pixel position of the plurality of pixels associated with the coded row run, wherein the coded row run comprises one or more consecutive gain map rows in the uncompressed gain map that each include at least one gain map entry of a gain less than unity, and wherein the uncoded row run comprises one or more consecutive gain map rows in the uncompressed gain map that each include gain map entries of only unity gain;
wherein the display pipeline circuitry further comprises internal memory configured to store the compressed gain map, wherein the compressed gain map comprises a starting row run indicator, a position gain value indicator, a run map, a position map, and a gain value map, and wherein the compressed gain map is determined based on the uncompressed gain map that explicitly maps each pixel position to a gain value,
wherein the run map indicates a number of gain map rows of the uncompressed gain map in the coded row run and the uncoded row run, wherein the position map indicates a number of gain map entries of the uncompressed gain map included in each gain run of the coded row run, and wherein the gain value map indicates the gain value associated with each pixel position in an intermediate gain run;
wherein the sub-pixel layout resampler circuitry is further configured to:
determine second image data that indicates target luminance of the first display pixel to display the image frame by processing the first image data based at least in part on the first gain value, wherein determining the second image data comprises:
determining whether a row of the first pixel position is in the coded row run or the uncoded row run using the run map and the starting row run indicator which indicates if the first row run is a coded row run or an uncoded row run;
in response to determining that the row of the first pixel position is in the uncoded row run, determining that the first gain value is unity gain;
in response to determining that the row of the first pixel position is in the coded row run, determining whether the row of the first pixel position is in the intermediate gain run of the coded row run or in a position gain run of the coded row run using the position map, wherein the position gain run comprises either a zero gain run or a unity gain run;
in response to determining that the first pixel position is in the intermediate gain run, wherein the intermediate gain run comprises one or more consecutive gain map entries associating a corresponding pixel position to at least one gain value greater than zero and less than unity, determining the first gain value using the gain value map; and
in response to determining that the first pixel position is in the position gain run, determining the first gain value using the position gain value indicator, wherein the position gain value indicator indicates if the position gain run is a zero gain run or a unity gain run; and
output the second image data to the electronic display to facilitate displaying a non-rectangular portion of the image frame on the display region.

2. A tangible, non-transitory, computer-readable medium storing instructions executable by one or more processors of an electronic device, wherein the instructions comprise instructions to:
determine, using the one or more processors, an uncompressed gain map comprising a plurality of gain map entries that each explicitly associates a corresponding pixel position with a gain value set;
determine, using the one or more processors, a compressed gain map based at least in part on the uncompressed gain map, wherein the instructions to determine the compressed gain map comprise instructions to:
determine a run map based at least in part on grouping of each gain map row of the uncompressed gain map into row runs, wherein each row run comprises either one or more consecutive gain map rows each categorized as a coded row or one or more consecutive gain map rows each categorized as an uncoded row, wherein the coded row defines the plurality of gain map entries having a gain less than unity for respective corresponding pixel positions, wherein the uncoded row defines the plurality of gain map entries having a unity gain for respective corresponding pixel positions, and wherein the run map indicates a number of gain map rows of the uncompressed gain map in the coded row run and the uncoded row, the step of determining the run map including generating a starting row run indicator which indicates if the first row run is a coded row run or an uncoded row run and counting the number of rows belonging to each of a coded row category and an uncoded row category;
determine a position map based at least in part on grouping of each gain map entry in coded rows of the uncompressed gain map into either a position gain run or an intermediate gain run, and generating a position gain value indicator indicating if the position gain run is a zero gain run or a unity gain run, wherein the position map indicates a number of gain map entries of the uncompressed gain map included in each gain run of the coded rows, wherein:
each intermediate gain run comprises one or more consecutive gain map entries each categorized as an intermediate gain entry associating a corresponding pixel position to at least one gain value greater than zero and less than unity; and
each position gain run comprises either one or more consecutive gain map entries each categorized as a unity gain entry or one or more consecutive gain map entries each categorized as a zero gain entry; and
determine a gain value map based at least in part on the gain value set indicated by each intermediate gain run entry; and
store the compressed gain map, comprising the generated starting row run indicator, position gain value indicator, run map, position map, and gain value map, in internal memory of a display pipeline circuitry configured to be communicatively coupled to an electronic display to enable the display pipeline circuitry to process image data corresponding with an image to be displayed on the electronic display based at least in part on gain values determined by reading the compressed gain map.

3. The computer-readable medium of claim 2, wherein the instructions to determine the uncompressed gain map comprise instructions to:
determine an anti-aliasing region along a rounded border of a display region of the electronic display;
determine a first gain map entry that explicitly associates a first pixel position in the anti-aliasing region to a first gain value set, wherein the first gain value set comprises a gain value greater than zero and less than unity; and
determine a second gain map entry that explicitly associates a second pixel position outside the anti-aliasing region and outside the display region to a second gain value set, wherein each gain value in the second gain value set is equal to zero to enable the display pipeline circuitry to apply a black mask on the image that facilitates displaying the image on the electronic display when the shape of the image and the display region differ.

## Patentansprüche

1. Elektronische Vorrichtung, aufweisend:
eine elektronische Anzeige, wobei die elektronische Anzeige aufweist:
einen Anzeigebereich mit einem abgerundeten Rand; und
ein erstes Anzeigepixel einer Vielzahl von Pixeln an einer ersten Pixelposition benachbart zu dem abgerundeten Rand; und
eine Anzeige-Pipeline-Schaltung, die eine oder mehrere Bilddatenverarbeitungsschaltungen aufweist, wobei die eine oder die mehreren Bilddatenverarbeitungsschaltungen eine Subpixel-Layout-Resampler-Schaltung aufweisen, wobei die Anzeige-Pipeline-Schaltung kommunikativ mit der elektronischen Anzeige gekoppelt ist, und wobei die Subpixel-Layout-Resampler-Schaltung konfiguriert ist zum:
Empfangen erster Bilddaten, die eine Zielleuchtdichte an der ersten Pixelposition in einem Bildrahmen angeben, wobei der Bildrahmen eine rechteckige Form aufweist;
Bestimmen eines ersten Verstärkungswerts, der mit der ersten Pixelposition assoziiert ist, aus einer komprimierten Verstärkungskarte, die auf einer unkomprimierten Verstärkungskarte basiert, wobei die komprimierte Verstärkungskarte einen codierten Zeilenlauf von einer oder mehreren codierten Zeilen der unkomprimierten Verstärkungskarte und einen uncodierten Zeilenlauf von einer oder mehreren uncodierten Zeilen der unkomprimierten Verstärkungskarte aufweist, wobei der codierte Zeilenlauf einen Verstärkungskarteneintrag eines Verstärkungswerts für eine jeweilige Pixelposition der Vielzahl von Pixeln, die mit dem codierten Zeilenlauf assoziiert sind, angibt, wobei der codierte Zeilenlauf eine oder mehrere aufeinanderfolgende Verstärkungskartenzeilen in der unkomprimierten Verstärkungskarte aufweist, die jeweils mindestens einen Verstärkungskarteneintrag einer Verstärkung von weniger als Eins enthalten, und wobei der uncodierte Zeilenlauf eine oder mehrere aufeinanderfolgende Verstärkungskartenzeilen in der unkomprimierten Verstärkungskarte aufweist, die jeweils Verstärkungskarteneinträge nur einer Verstärkung von Eins enthalten;
wobei die Anzeige-Pipeline-Schaltung ferner einen internen Speicher aufweist, der konfiguriert ist zum Speichern der komprimierten Verstärkungskarte, wobei die komprimierte Verstärkungskarte einen Startzeilenlaufindikator, einen Positionsverstärkungswertindikator, eine Laufkarte, eine Positionskarte und eine Verstärkungswertkarte aufweist, und wobei die komprimierte Verstärkungskarte basierend auf der unkomprimierten Verstärkungskarte bestimmt wird, die explizit jede Pixelposition auf einen Verstärkungswert abbildet,
wobei die Laufkarte eine Anzahl von Verstärkungskartenzeilen der unkomprimierten Verstärkungskarte in dem codierten Zeilenlauf und dem uncodierten Zeilenlauf angibt, wobei die Positionskarte eine Anzahl von Verstärkungskarteneinträgen der unkomprimierten Verstärkungskarte angibt, die in jedem Verstärkungslauf des codierten Zeilenlaufs enthalten sind, und wobei die Verstärkungswertkarte den Verstärkungswert angibt, der mit jeder Pixelposition in einem Zwischenverstärkungslauf assoziiert ist;
wobei die Subpixel-Layout-Resampler-Schaltung ferner konfiguriert ist zum:
Bestimmen zweiter Bilddaten, die eine Zielleuchtdichte des ersten Anzeigepixels zum Anzeigen des Bildrahmens angeben, durch Verarbeiten der ersten Bilddaten basierend zumindest teilweise auf dem ersten Verstärkungswert, wobei das Bestimmen der zweiten Bilddaten aufweist:
Bestimmen, ob eine Zeile der ersten Pixelposition in dem codierten Zeilenlauf oder dem uncodierten Zeilenlauf ist, unter Verwendung der Laufkarte und des Startzeilenlaufindikators, der angibt, ob der erste Zeilenlauf ein codierter Zeilenlauf oder ein uncodierter Zeilenlauf ist;
als Reaktion auf das Bestimmen, dass die Zeile der ersten Pixelposition in dem uncodierten Zeilenlauf ist, Bestimmen, dass der erste Verstärkungswert eine Verstärkung von Eins ist;
als Reaktion auf das Bestimmen, dass die Zeile der ersten Pixelposition in dem codierten Zeilenlauf ist, Bestimmen, ob die Zeile der ersten Pixelposition in dem Zwischenverstärkungslauf des codierten Zeilenlaufs oder in einem Positionsverstärkungslauf des codierten Zeilenlaufs ist, unter Verwendung der Positionskarte, wobei der Positionsverstärkungslauf entweder einen Nullverstärkungslauf oder einen Verstärkungslauf von Eins aufweist;
als Reaktion auf das Bestimmen, dass die erste Pixelposition in dem Zwischenverstärkungslauf ist, wobei der Zwischenverstärkungslauf einen oder mehrere aufeinanderfolgende Verstärkungskarteneinträge aufweist, die eine entsprechende Pixelposition mit mindestens einem Verstärkungswert von mehr als Null und weniger als Eins assoziieren, Bestimmen des ersten Verstärkungswerts unter Verwendung der Verstärkungswertkarte; und
als Reaktion auf das Bestimmen, dass die erste Pixelposition in dem Positionsverstärkungslauf ist, Bestimmen des ersten Verstärkungswerts unter Verwendung des Positionsverstärkungswertindikators, wobei der Positionsverstärkungswertindikator angibt, ob der Positionsverstärkungslauf ein Nullverstärkungslauf oder ein Verstärkungslauf von Eins ist; und
Ausgeben der zweiten Bilddaten an die elektronische Anzeige, um das Anzeigen eines nicht rechteckigen Abschnitts des Bildrahmens auf dem Anzeigebereich zu erleichtern.

2. Gegenständliches, nichtflüchtiges, computerlesbares Medium, das Anweisungen speichert, die durch einen oder mehrere Prozessoren einer elektronischen Vorrichtung ausführbar sind, wobei die Anweisungen Anweisungen aufweisen zum:
Bestimmen, unter Verwendung des einen oder der mehreren Prozessoren, einer unkomprimierten Verstärkungskarte, die eine Vielzahl von Verstärkungskarteneinträgen aufweist, die jeweils eine entsprechende Pixelposition explizit mit einem Verstärkungswertsatz assoziieren;
Bestimmen, unter Verwendung des einen oder der mehreren Prozessoren, einer komprimierten Verstärkungskarte basierend zumindest teilweise auf der unkomprimierten Verstärkungskarte, wobei die Anweisungen zum Bestimmen der komprimierten Verstärkungskarte Anweisungen aufweisen zum:
Bestimmen einer Laufkarte basierend zumindest teilweise auf dem Gruppieren jeder Verstärkungskartenzeile der unkomprimierten Verstärkungskarte in Zeilenläufe, wobei jeder Zeilenlauf entweder eine oder mehrere aufeinanderfolgende Verstärkungskartenzeilen, die jeweils als eine codierte Zeile kategorisiert sind, oder eine oder mehrere aufeinanderfolgende Verstärkungskartenzeilen, die jeweils als eine uncodierte Zeile kategorisiert sind, aufweist, wobei die codierte Zeile die Vielzahl von Verstärkungskarteneinträgen mit einer Verstärkung von weniger als Eins für jeweilige entsprechende Pixelpositionen definiert, wobei die uncodierte Zeile die Vielzahl von Verstärkungskarteneinträgen mit einer Verstärkung von Eins für jeweilige entsprechende Pixelpositionen definiert, und wobei die Laufkarte eine Anzahl von Verstärkungskartenzeilen der unkomprimierten Verstärkungskarte in dem codierten Zeilenlauf und der uncodierten Zeile angibt, wobei der Schritt des Bestimmens der Laufkarte das Erzeugen eines Startzeilenlaufindikators, der angibt, ob der erste Zeilenlauf ein codierter Zeilenlauf oder ein uncodierter Zeilenlauf ist, und das Zählen der Anzahl von Zeilen, die zu jeder von einer codierten Zeilenkategorie und einer uncodierten Zeilenkategorie gehören, enthält;
Bestimmen einer Positionskarte basierend zumindest teilweise auf dem Gruppieren jedes Verstärkungskarteneintrags in codierten Zeilen der unkomprimierten Verstärkungskarte in entweder einen Positionsverstärkungslauf oder einen Zwischenverstärkungslauf und Erzeugen eines Positionsverstärkungswertindikators, der angibt, ob der Positionsverstärkungslauf ein Nullverstärkungslauf oder ein Verstärkungslauf von Eins ist, wobei die Positionskarte eine Anzahl von Verstärkungskarteneinträgen der unkomprimierten Verstärkungskarte angibt, die in jedem Verstärkungslauf der codierten Zeilen enthalten sind, wobei:
jeder Zwischenverstärkungslauf einen oder mehrere aufeinanderfolgende Verstärkungskarteneinträge aufweist, die jeweils als ein Zwischenverstärkungseintrag kategorisiert sind, der eine entsprechende Pixelposition mit mindestens einem Verstärkungswert von mehr als Null und weniger als Eins assoziiert; und
jeder Positionsverstärkungslauf entweder einen oder mehrere aufeinanderfolgende Verstärkungskarteneinträge, die jeweils als ein Verstärkungseintrag von Eins kategorisiert sind, oder einen oder mehrere aufeinanderfolgende Verstärkungskarteneinträge, die jeweils als ein Verstärkungseintrag von Null kategorisiert sind, aufweist; und
Bestimmen einer Verstärkungswertkarte basierend zumindest teilweise auf dem Verstärkungswertsatz, der durch jeden Zwischenverstärkungslaufeintrag angegeben wird; und
Speichern der komprimierten Verstärkungskarte, die den erzeugten Startzeilenlaufindikator, Positionsverstärkungswertindikator, Laufkarte, Positionskarte und Verstärkungswertkarte aufweist, in einem internen Speicher einer Anzeige-Pipeline-Schaltung, die konfiguriert ist, um kommunikativ mit einer elektronischen Anzeige gekoppelt zu werden, um es der Anzeige-Pipeline-Schaltung zu ermöglichen, Bilddaten zu verarbeiten, die einem auf der elektronischen Anzeige anzuzeigenden Bild entsprechen, basierend zumindest teilweise auf Verstärkungswerten, die durch Lesen der komprimierten Verstärkungskarte bestimmt werden.

3. Computerlesbares Medium nach Anspruch 2, wobei die Anweisungen zum Bestimmen der unkomprimierten Verstärkungskarte Anweisungen aufweisen zum:
Bestimmen eines Anti-Aliasing-Bereichs entlang eines abgerundeten Rands eines Anzeigebereichs der elektronischen Anzeige;
Bestimmen eines ersten Verstärkungskarteneintrags, der explizit eine erste Pixelposition in dem Anti-Aliasing-Bereich mit einem ersten Verstärkungswertsatz assoziiert, wobei der erste Verstärkungswertsatz einen Verstärkungswert von mehr als Null und weniger als Eins aufweist; und
Bestimmen eines zweiten Verstärkungskarteneintrags, der explizit eine zweite Pixelposition außerhalb des Anti-Aliasing-Bereichs und außerhalb des Anzeigebereichs mit einem zweiten Verstärkungswertsatz assoziiert, wobei jeder Verstärkungswert in dem zweiten Verstärkungswertsatz gleich Null ist, um es der Anzeige-Pipeline-Schaltung zu ermöglichen, eine schwarze Maske auf das Bild anzuwenden, die das Anzeigen des Bilds auf der elektronischen Anzeige erleichtert, wenn sich die Form des Bilds und des Anzeigebereichs unterscheiden.

## Revendications

1. Un dispositif électronique, comprenant :
un afficheur électronique, l'afficheur électronique comprenant :
une région d'affichage avec un bord arrondi ; et
un premier pixel d'affichage d'une pluralité de pixels au niveau d'une première position de pixel adjacente au bord arrondi ; et
une circuiterie de pipeline d'affichage comprenant un ou plusieurs circuits de traitement de données d'image, les un ou plusieurs circuits de traitement de données d'image comprenant une circuiterie de rééchantillonnage de disposition de sous-pixels, la circuiterie de pipeline d'affichage étant couplée de manière communicante à l'afficheur électronique, et le circuit de rééchantillonnage de disposition de sous-pixels étant configuré pour :
recevoir des premières données d'image qui indiquent une luminance cible au niveau de la première position de pixel dans une trame d'image, la trame d'image ayant une forme rectangulaire ;
déterminer une première valeur de gain associée à la première position de pixel à partir d'une mappe de gain compressée qui est basée sur une mappe de gain non compressée, la mappe de gain compressée comprenant une suite de rangées codées d'une ou plusieurs rangées codées de la mappe de gain non compressée et une suite de rangées non codées d'une ou plusieurs rangées non codées de la mappe de gain non compressée, la suite de rangées codées indiquant une rubrique de mappe de gain d'une valeur de gain pour une position de pixel respective de la pluralité de pixels associée à la suite de rangées codées, la suite de rangées codées comprenant une ou plusieurs rangées de mappe de gain consécutives de la mappe de gain non compressée, qui comprennent chacune au moins une rubrique de mappe de gain d'un gain inférieur à l'unité, et la suite de rangées non codées comprenant une ou plusieurs rangées de mappe de gain consécutives de la mappe de gain non compressée qui comprennent chacune des rubriques de mappe de gain uniquement de gain unité ;
dans lequel la circuiterie de pipeline d'affichage comprend en outre une mémoire interne configurée pour stocker la mappe de gain compressée, la mappe de gain compressée comprenant un indicateur de début de suite de rangées, un indicateur de valeur de gain de position, une mappe de suite, une mappe de position, une mappe de valeur de gain, et la mappe de gain compressée étant déterminée sur la base de la mappe de gain non compressée qui mappe explicitement chaque position de pixel à une valeur de gain,
dans lequel la mappe de suite indique un nombre de rangées de mappe de gain de la mappe de gain non compressée dans la suite de rangées codée et la suite de rangées non codée, dans lequel la mappe de position indique un nombre de rubriques de mappe de gain de la mappe de gain non compressée incluse dans chaque suite de gain de la suite de rangées codée, et dans lequel la mappe de valeur de gain indique la valeur de gain associée à chaque position de pixel dans une suite de gain intermédiaire ;
dans lequel la circuiterie de rééchantillonnage de disposition de sous-pixels est en outre configurée pour :
déterminer des secondes données d'image qui indiquent une luminance cible du premier pixel d'affichage pour l'affichage de la trame d'image par traitement des premières données d'image au moins en partie sur la base de la première valeur de gain, la détermination des secondes données d'image comprenant :
la détermination si une rangée de la première position de pixel est dans la suite de rangées codée ou bien la suite de rangées non codée en utilisant la mappe de suite et l'indicateur de début de suite de rangées qui indique si la première suite de rangées est une suite de rangées codée ou bien une suite de rangées non codée ;
en réponse à la détermination que la rangée de la première position de pixel est dans la suite de rangées non codée, la détermination que la première valeur de gain est un gain unité ;
en réponse à la détermination que la rangée de la première position de pixel est dans la suite de rangées codée, la détermination si la rangée de la première position de pixel est dans la suite de gain intermédiaire de la suite de rangées codée ou bien dans une suite de gain de position de la suite de rangées codée en utilisant la mappe de position, la suite de gain de position comprenant soit une suite de gain nul ou une suite de gain unité ;
en réponse à la détermination que la première position de pixel est dans la suite de gain intermédiaire, la suite de gain intermédiaire comprenant une ou plusieurs rubriques de mappe de gain consécutives associant une position de pixel correspondant à au moins une valeur de gain supérieure à zéro et inférieure à l'unité, la détermination de la première valeur de gain en utilisant la mappe de valeur de gain ; et
en réponse à la détermination que la première position de pixel est dans la suite de gain de position, la détermination de la première valeur de gain en utilisant l'indicateur de valeur de gain de position, l'indicateur de valeur de gain de position indiquant si la suite de gain de position est une suite de gain nul ou une suite de gain unité ; et
délivrer en sortie les secondes données d'image à l'afficheur électronique pour faciliter l'affichage d'une partie non rectangulaire de la trame d'image sur la région d'affichage.

2. Un support tangible, non transitoire, lisible par calculateur stockant des instructions exécutables par un ou plusieurs processeurs d'un dispositif électronique, les instructions comprenant des instructions pour :
déterminer, en utilisant les un ou plusieurs processeurs, une mappe de gain non compressée comprenant une pluralité de rubriques de mappe de gain qui associent chacune explicitement une position de pixel correspondante avec un ensemble de valeurs de gain ;
déterminer, en utilisant les un ou plusieurs processeurs, une mappe de gain compressée basée au moins en partie sur la mappe de gain non compressée, les instructions pour déterminer la mappe de gain compressée comprenant des instructions pour :
déterminer une mappe de suite basée au moins en partie sur le regroupement de chaque rangée de mappe de gain de la mappe de gain non compressée en suite de rangées, chaque suite de rangées comprenant soit une ou plusieurs rangées de mappe de gain consécutives catégorisée chacune en tant que rangée codée, soit une ou plusieurs rangées de mappe de gain consécutives catégorisées chacune en tant que rangées non codées, la rangée codée définissant la pluralité de rubriques de mappe de gain ayant un gain inférieur à l'unité pour des positions de pixel respectives correspondantes, la rangée non codée définissant la pluralité de rubriques de mappe de gain ayant un gain unité pour des positions de pixel respectives correspondantes, et la mappe de suite indiquant un nombre de rangées de suites de gain de la mappe de gain non compressée de la suite de rangées codée et de la rangée codée, l'étape de détermination de la mappe de suite comprenant la génération d'un indicateur de début de suite de rangées qui indique si la première suite de rangées est une suite de rangées codée ou une suite de rangées non codée, et le comptage du nombre de rangées appartenant à chacune d'entre une catégorie de rangées codée et une catégorie de rangées non codée ;
déterminer une mappe de position au moins en partie basée sur le regroupement de chaque rubrique de mappe de gain en rangées codées de la mappe de gain non compressée soit en une suite de gain de position soit en une suite de gain intermédiaire, et la génération d'un indicateur de valeur de gain de position indiquant si la suite de gain de position est une suite de gain nul ou une suite de gain unité, la mappe de position indiquant un nombre de rubriques de mappe de gain de la mappe de gain non compressée incluses dans chaque suite de gain des rangées codées, dans lequel :
chaque suite de gain intermédiaire comprend une ou plusieurs rubriques de mappe de gain consécutives catégorisée chacune en tant que rubrique de gain intermédiaire associant une position de pixel correspondant à au moins une valeur de gain supérieure à zéro et inférieure à l'unité ; et
chaque suite de gain de position comprend soit une ou plusieurs rubriques de mappe de gain consécutives catégorisées chacune en tant que rubrique de gain unité soit une ou plusieurs rubriques de mappe de gain consécutives catégorisées chacune en tant que rubrique de gain nul ; et
déterminer une mappe de valeur de gain au moins en partie sur la base de l'ensemble de valeur de gain indiqué par chaque rubrique de suite de gain intermédiaire ; et
stocker la mappe de gain compressée, comprenant l'indicateur de début de suite de rangées, l'indicateur de valeur de position de gain, la mappe de suite, la mappe de position, et la mappe de valeur de gain, dans une mémoire interne d'une circuiterie de pipeline d'affichage configurée pour être couplée de manière communicante à un afficheur électronique, pour permettre à la circuiterie de pipeline d'affichage de traiter des données d'image correspondant à une image à afficher sur l'afficheur électronique au moins en partie sur la base de valeurs de gain déterminées par lecture de la mappe de gain compressée.

3. Le support lisible par calculateur de la revendication 2, dans lequel les instructions pour déterminer la mappe de gain non compressée comprennent des instructions pour :
déterminer une région d'antialiasing le long d'un bord arrondi d'une région d'affichage de l'afficheur électronique ;
déterminer une première rubrique de mappe de gain qui associe explicitement une première position de pixel dans la région d'antialiasing à un premier ensemble de valeurs de gain, le premier ensemble de valeurs de gain comprenant une valeur de gain supérieure à zéro et inférieure à l'unité ; et
déterminer une seconde rubrique de mappe de gain qui associe explicitement une seconde position de pixel en dehors de la région d'antialiasing et en dehors de la région d'affichage à un second ensemble de valeurs de gain, chaque valeur de gain du second ensemble de valeurs de gain étant égale à zéro pour permettre à la circuiterie de pipeline d'affichage d'appliquer un masque noir sur l'image qui facilite l'affichage de l'image sur l'afficheur électronique lorsque la forme de l'image et la région d'affichage diffèrent.
